(19) Europäisches Patentamt
European Patent Office
Office européen des brevets

(11) **EP 4 669 067 A1**

(12) **EUROPEAN PATENT APPLICATION**

(43) Date of publication:
**24.12.2025 Bulletin 2025/52**

(21) Application number: **24182648.6**

(22) Date of filing: **17.06.2024**

(51) International Patent Classification (IPC):
***H10K 50/16** (2023.01)* ***H10K 59/32** (2023.01)*
***H10K 85/40** (2023.01)* ***H10K 85/60** (2023.01)*
***C07D 253/075** (2006.01)*

(52) Cooperative Patent Classification (CPC):
**H10K 85/6572; H10K 50/166; H10K 59/32;**
**H10K 85/40; H10K 85/615; H10K 85/654;**
**H10K 85/6574;** H10K 2101/30

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(71) Applicant: **Novaled GmbH**
**01099 Dresden (DE)**

(72) Inventors:
- **Karpov, Yevhen**
  **01099 Dresden (DE)**
- **Galán García, Elena**
  **01099 Dresden (DE)**
- **Huang, Qiang**
  **01099 Dresden (DE)**

(74) Representative: **Erbacher, Martin**
**Boehmert & Boehmert**
**Anwaltspartnerschaft mbB**
**Pettenkoferstrasse 22**
**80336 München (DE)**

(54) **ORGANIC LIGHT EMITTING DIODE, AND DISPLAY DEVICE**

(57) The present invention relates to a compound, to an organic light emitting device, and to a display device comprising the same.

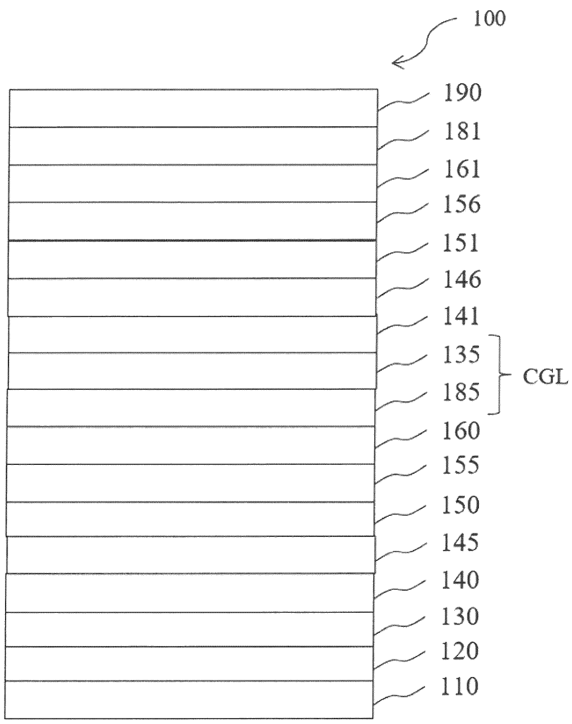


Fig. 1

EP 4 669 067 A1

## Description

TECHNICAL FIELD

The present invention relates to an organic light emitting diode and to a display device comprising the organic light emitting diode, and to a process for preparing the organic light emitting diode.

BACKGROUND OF THE INVENTION

Organic semiconducting devices, such as organic light-emitting diodes OLEDs, which are self-emitting devices, have a wide viewing angle, excellent contrast, quick response, high brightness, excellent operating voltage characteristics, and color reproduction. A typical OLED comprises an anode, a hole transport layer HTL, an emission layer EML, an electron transport layer ETL, and a cathode, which are sequentially stacked on a substrate. In this regard, the HTL, the EML, and the ETL are thin films formed from organic compounds.

When a voltage is applied to the anode and the cathode, holes injected from the anode move to the EML, via the HTL, and electrons injected from the cathode move to the EML, via the ETL. The holes and electrons recombine in the EML to generate excitons. When the excitons drop from an excited state to a ground state, light is emitted. The injection and flow of holes and electrons should be balanced, so that an OLED having the above-described structure has excellent efficiency and/or a long lifetime.

Performance of an organic light emitting diode may be affected by characteristics of the organic semiconductor layer, and among them, may be affected by characteristics of an organic material of the organic semiconductor layer.

Particularly, development of an organic semiconductor layer being capable of increasing electron mobility and simultaneously increasing electrochemical stability is needed so that the organic semiconducting device, such as an organic light emitting diode, may be applied to a large-size flat panel display.

It is, therefore, the object of the present invention to provide organic light emitting diodes overcoming drawbacks of the prior art, in particular providing organic light emitting diodes with improved performance, especially with respect to efficiency and/or operating voltage an/or lifetime and/or voltage rise.

DISCLOSURE

This object is achieved by an organic light emitting diode comprising an anode, a cathode, a first emission layer, a second emission layer, an n-type charge generation layer, an electron transport layer,
wherein

- the n-type charge generation layer is arranged between the first emission layer and the second emission layer;

- electron transport layer is arranged between the first emission layer and the second emission layer;

- the n-type charge generation layer comprises a heterocyclic compound nCG, wherein the heterocyclic compound nCG comprising at least one five-membered ring comprising at least one N-atom and/or at least one six-membered ring comprising at least one N-atom;

- the electron transport layer comprises a compound of Formula (I)

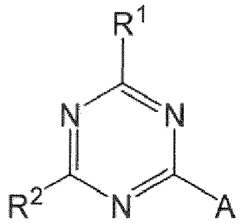

(I)

- $R^1$ is selected from the group consisting of unsubstituted or substituted $C_6$ to $C_{12}$ aryl,

  - wherein if $R^1$ is substituted $C_6$ to $C_{12}$ aryl, the one or more substituent(s) are independently selected from the group consisting of D, $C_1$ to $C_6$ alkyl, $C_1$ to $C_6$ alkoxy, partially or perfluorinated $C_1$ to $C_6$ alkyl, partially or perfluorinated $C_1$ to $C_6$ alkoxy, partially or perdeuterated $C_1$ to $C_6$ alkyl, partially or perdeuterated $C_1$ to $C_6$ alkoxy;

halogen, CN or $PY(R^{10})_2$, wherein Y is selected from O, S or Se, and $R^{10}$ is independently selected from $C_6$ to $C_{12}$ aryl, $C_3$ to $C_{12}$ heteroaryl, $C_1$ to $C_6$ alkyl, $C_1$ to $C_6$ alkoxy, partially or perfluorinated $C_1$ to $C_6$ alkyl, partially or perfluorinated $C_1$ to $C_6$ alkoxy, partially or perdeuterated $C_1$ to $C_6$ alkyl, partially or perdeuterated $C_1$ to $C_6$ alkoxy;

- A is selected from the group consisting of unsubstituted or substituted $C_{10}$ to $C_{12}$ aryl and unsubstituted or substituted $C_{10}$ to $C_{12}$ heteroaryl,

  - wherein if A is substituted $C_{10}$ to $C_{12}$ aryl or substituted $C_{10}$ to $C_{12}$ heteroaryl, the one or more substituent(s) are independently selected from the group consisting of D, $C_1$ to $C_6$ alkyl, $C_1$ to $C_6$ alkoxy, partially or perfluorinated $C_1$ to $C_6$ alkyl, partially or perfluorinated $C_1$ to $C_6$ alkoxy, partially or perdeuterated $C_1$ to $C_6$ alkyl, partially or perdeuterated $C_1$ to $C_6$ alkoxy; halogen, CN or $PY(R^{10})_2$, wherein Y is selected from O, S or Se, and $R^{10}$ is independently selected from $C_6$ to $C_{12}$ aryl, $C_3$ to $C_{12}$ heteroaryl, $C_1$ to $C_6$ alkyl, $C_1$ to $C_6$ alkoxy, partially or perfluorinated $C_1$ to $C_6$ alkyl, partially or perfluorinated $C_1$ to $C_6$ alkoxy, partially or perdeuterated $C_1$ to $C_6$ alkyl, partially or perdeuterated $C_1$ to $C_6$ alkoxy;

- $R^2$ is a group of Formula (II)

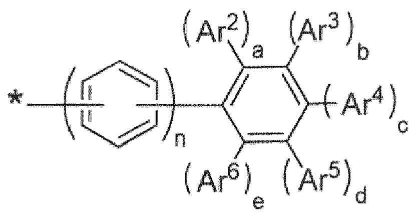

(II)

- * represents the binding position to the remaining structure of Formula (I);

- a, b, c, d, e are independently 0 or 1, wherein $1 \leq a+b+c+d+e \leq 5$;

- "n" is 0, 1, or 2;

- $Ar^2$, $Ar^3$, $Ar^4$, $Ar^5$, and $Ar^6$ are independently selected from the group consisting of substituted or unsubstituted $C_6$ to $C_{12}$ aryl and substituted or unsubstituted $C_4$ to $C_{10}$ heteroaryl,

  - wherein if one or more of $Ar^2$, $Ar^3$, $Ar^4$, $Ar^5$, and $Ar^6$ is substituted, the one or more substituent(s) are independently selected from the group consisting of D, $C_1$ to $C_6$ alkyl, $C_1$ to $C_6$ alkoxy, partially or perdeuterated $C_1$ to $C_6$ alkyl, partially or perdeuterated $C_1$ to $C_6$ alkoxy, partially or perfluorinated $C_1$ to $C_6$ alkyl, partially or perfluorinated $C_1$ to $C_6$ alkoxy, F, and CN;

  - the dipole moment of the compound of Formula (I) is $\geq 0$ D and $\leq 1$ D;

  - A is chosen so that the dipole moment of a compound "A-phenyl" is $\geq 0$ D and $\leq 1$ D; and

  - the electron transport layer is free from an electrical dopant.

This object is further achieved by a display device comprising the organic light emitting diode according to the present invention.

Surprisingly, it was found that the organic light emitting diodes and display devices according to the present invention have improved properties in comparison with respective devices of the prior art, especially have improved efficiency, improved lifetime, reduced operating voltage and reduced voltage increase over lifetime.

<u>Compound of formula (I)</u>

The organic light emitting diode according to the present invention comprises in the electron transport layer thereof comprises a compound of Formula (1)

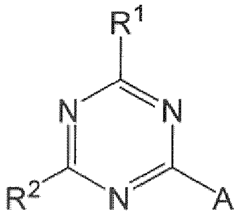 (I).

Especially, if not mentioned else explicitly, all compounds, especially the compound of formula (I), groups, moieties, substituents etc. shown herein, especially by structural formulas, by systematic names etc. encompass the respective partially and fully deuterated derivatives thereof, wherein it may be provided that substitution beyond deuteration is excluded. If a compound, group, moiety, substituent etc. is mentioned to be unsubstituted, this does not exclude substitution with D.

In accordance with the present disclosure, as an illustrative example using an arbitrary group A in a formula showing the following binding situation,

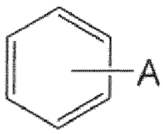

the group A may be bound to any suitable binding position.

In the compound of Formula (I), $R^1$ is selected from the group consisting of unsubstituted or substituted $C_6$ to $C_{12}$ aryl. $R^1$ may be selected from the group consisting of unsubstituted or substituted phenyl, unsubstituted or substituted naphthyl and unsubstituted or substituted biphenyl.

$R^1$ may be selected from

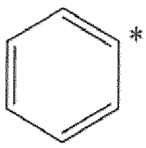 ; 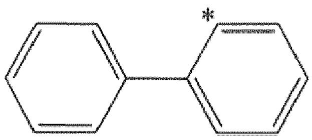 ; and 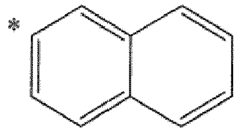

wherein * represents the binding position of $R^1$ to

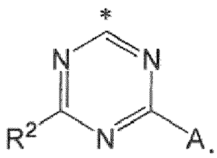.

$R^1$ may be selected from the group consisting of unsubstituted or substituted phenyl and unsubstituted or substituted biphenyl.

$R^1$ may be selected from

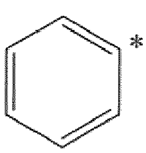 and 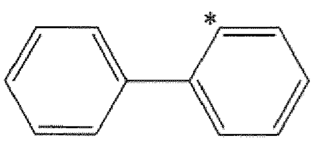

wherein * represents the binding position of $R^1$ to

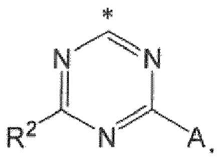

If $R^1$ is substituted, the one or more substituent(s) are independently selected from the group consisting of D, $C_1$ to $C_6$ alkyl, $C_1$ to $C_6$ alkoxy, partially or perfluorinated $C_1$ to $C_6$ alkyl, partially or perfluorinated $C_1$ to $C_6$ alkoxy, partially or perdeuterated $C_1$ to $C_6$ alkyl, partially or perdeuterated $C_1$ to $C_6$ alkoxy; halogen, CN or $PY(R^{10})_2$, wherein Y is selected from O, S or Se, and $R^{10}$ is independently selected from $C_6$ to $C_{12}$ aryl, $C_3$ to $C_{12}$ heteroaryl, $C_1$ to $C_6$ alkyl, $C_1$ to $C_6$ alkoxy, partially or perfluorinated $C_1$ to $C_6$ alkyl, partially or perfluorinated $C_1$ to $C_6$ alkoxy, partially or perdeuterated $C_1$ to $C_6$ alkyl, partially or perdeuterated $C_1$ to $C_6$ alkoxy. The one or more substituent(s) may be independently selected from the group consisting of D, $C_1$ to $C_6$ alkyl, $C_1$ to $C_6$ alkoxy, partially or perfluorinated $C_1$ to $C_6$ alkyl, partially or perfluorinated $C_1$ to $C_6$ alkoxy, partially or perdeuterated $C_1$ to $C_6$ alkyl, partially or perdeuterated $C_1$ to $C_6$ alkoxy. The one or more substituent(s) may be independently selected from the group consisting of D, $C_1$ to $C_6$ alkyl. The one or more substituent(s) may be independently D.

A is selected from the group consisting of unsubstituted or substituted $C_{10}$ to $C_{13}$ aryl and unsubstituted or substituted $C_{10}$ to $C_{12}$ heteroaryl. A may be selected from the group consisting of unsubstituted or substituted $C_{10}$ to $C_{13}$ aryl and unsubstituted or substituted O-containing $C_{10}$ to $C_{12}$ heteroaryl. A may selected from the group consisting of unsubstituted or substituted naphthyl, unsubstituted or substituted biphenyl, unsubstituted or substituted dibenzothiofuranyl unsubstituted or substituted dibenzofuranyl, and unsubstituted or substituted fluorenyl. A may selected from the group consisting of unsubstituted or substituted naphthyl, unsubstituted or substituted biphenyl, unsubstituted or substituted dibenzofuranyl, and unsubstituted or substituted fluorenyl.

A may be selected from the group consisting of

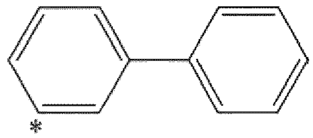 ; 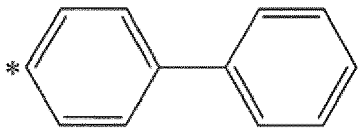 ;; 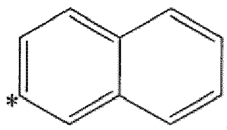 ; 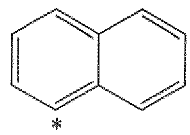 ;

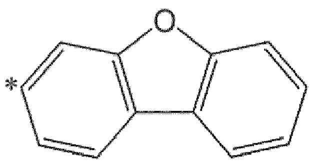 ; 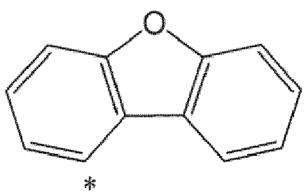 ; 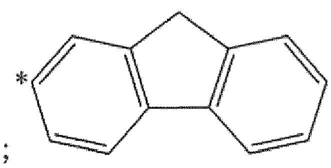 ;

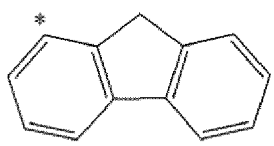 ; 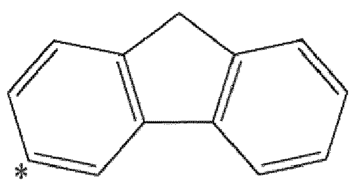 ; 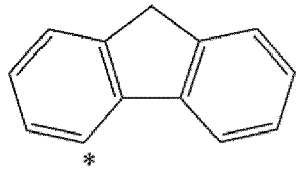

wherein * represents the binding position of A to

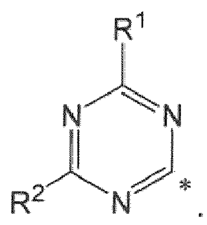

A may selected from the group consisting of unsubstituted or substituted biphenyl, unsubstituted or substituted dibenzofuranyl and unsubstituted or substituted fluorenyl.

A may be selected from the group consisting of

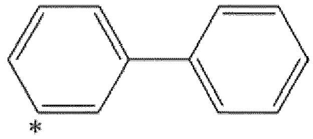 ; 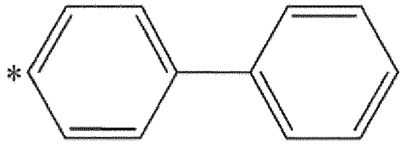 ; 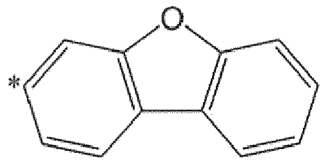 ;

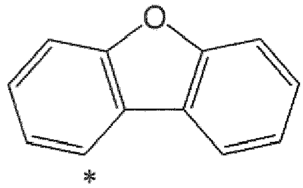 ; 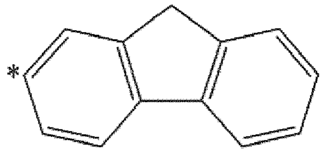 ; 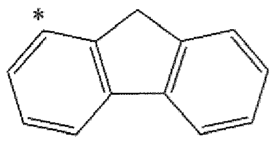 ;

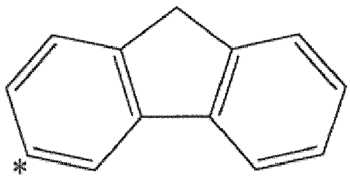 ; 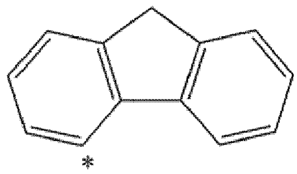

wherein * represents the binding position of A to

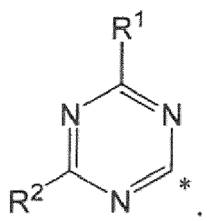

If A is substituted, the one or more substituent(s) are independently selected from the group consisting of D, $C_1$ to $C_6$ alkyl, phenyl, $C_1$ to $C_6$ alkoxy, partially or perfluorinated $C_1$ to $C_6$ alkyl, partially or perfluorinated $C_1$ to $C_6$ alkoxy, partially or perdeuterated $C_1$ to $C_6$ alkyl, partially or perdeuterated $C_1$ to $C_6$ alkoxy; halogen, CN or $PY(R^{10})_2$, wherein Y is selected from O, S or Se, and $R^{10}$ is independently selected from $C_6$ to $C_{12}$ aryl, $C_3$ to $C_{12}$ heteroaryl, $C_1$ to $C_6$ alkyl, $C_1$ to $C_6$ alkoxy, partially or perfluorinated $C_1$ to $C_6$ alkyl, partially or perfluorinated $C_1$ to $C_6$ alkoxy, partially or perdeuterated $C_1$ to $C_6$ alkyl, partially or perdeuterated $C_1$ to $C_6$ alkoxy. The one or more substituent(s) may be independently selected from the group consisting of D, $C_1$ to $C_6$ alkyl, $C_1$ to $C_6$ alkoxy, partially or perfluorinated $C_1$ to $C_6$ alkyl, partially or perfluorinated $C_1$ to $C_6$ alkoxy, partially or perdeuterated $C_1$ to $C_6$ alkyl, partially or perdeuterated $C_1$ to $C_6$ alkoxy.

The one or more substituent(s) may be independently selected from the group consisting of D, $C_1$ to $C_6$ alkyl. The one or more substituent(s) may be independently D.

If A is substituted, the one or more substituent(s) are independently selected from the group consisting of D, $C_1$ to $C_6$ alkyl, phenyl, $C_1$ to $C_6$ alkoxy, partially or perfluorinated $C_1$ to $C_6$ alkyl, partially or perfluorinated $C_1$ to $C_6$ alkoxy, partially or perdeuterated Ct to $C_6$ alkyl, partially or perdeuterated $C_1$ to $C_6$ alkoxy.

If A is substituted, the one or more substituent(s) are independently selected from the group consisting of D, $C_1$ to $C_6$ alkyl, phenyl.

If A is substituted, the one or more substituent(s) may be independently selected from the group consisting of D, methyl, and phenyl.

If A is substituted with two phenyl on the same C-atom, the two phenyl may be connected with each other via a single bond to form a ring.

If A is substituted, A containing all substituents may be selected from the group consisting of

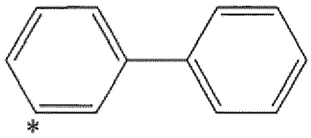; 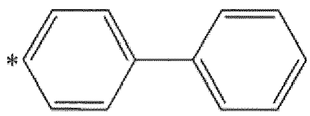; 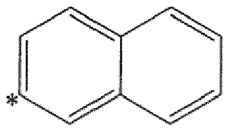; 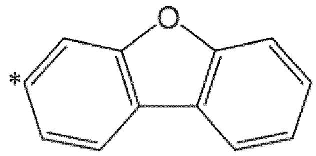;

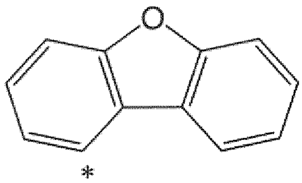 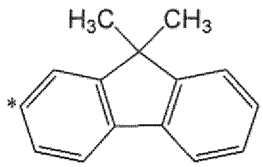; 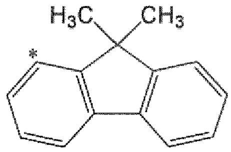; 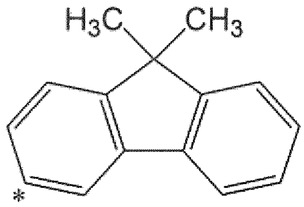;

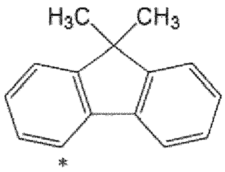; 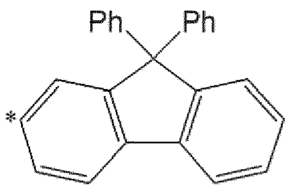; 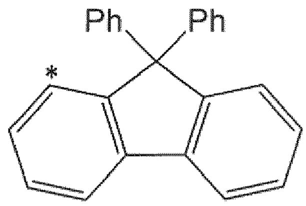; 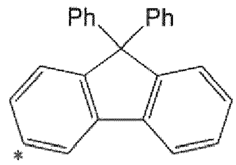;

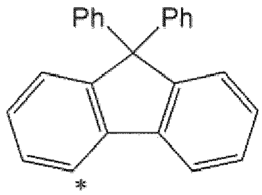

wherein * represents the binding position of A to

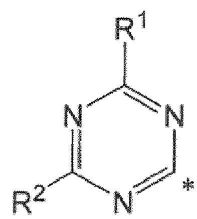.

A is selected from the group consisting of unsubstituted or substituted $C_{10}$ to $C_{12}$ aryl and unsubstituted or substituted $C_{10}$ to $C_{12}$ heteroaryl. A may be selected from the group consisting of unsubstituted or substituted $C_{10}$ to $C_{12}$ aryl and unsubstituted or substituted O-containing $C_{10}$ to $C_{12}$ heteroaryl. A may selected from the group consisting of unsubstituted or substituted naphthyl, unsubstituted or substituted biphenyl, unsubstituted or substituted dibenzothiofuranyl and unsubstituted or substituted dibenzofuranyl. A may selected from the group consisting of unsubstituted or substituted naphthyl, unsubstituted or substituted biphenyl, and unsubstituted or substituted dibenzofuranyl.

A may be selected from the group consisting of

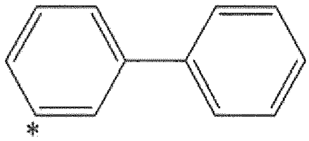; 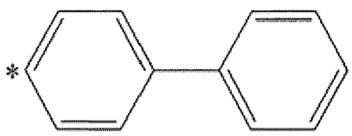; 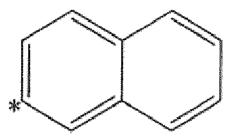;

and

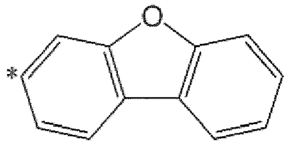 ; 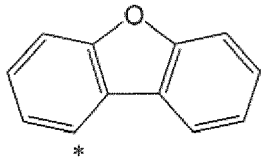

wherein * represents the binding position of A to

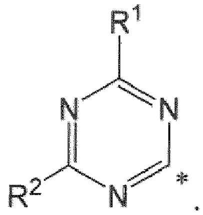

A may selected from the group consisting of unsubstituted or substituted biphenyl, and unsubstituted or substituted dibenzofuranyl.

A may be selected from the group consisting of

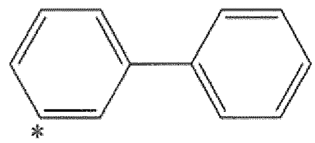 ; 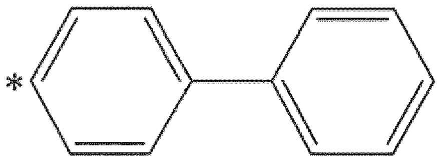 ; and 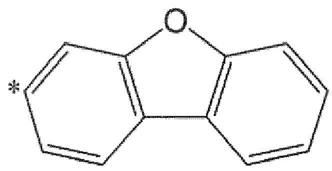 ;

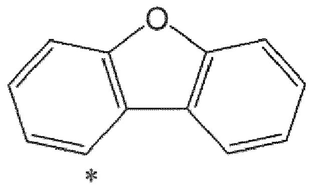

wherein * represents the binding position of A to

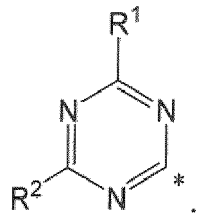

If A is substituted, the one or more substituent(s) are independently selected from the group consisting of D, $C_1$ to $C_6$ alkyl, $C_1$ to $C_6$ alkoxy, partially or perfluorinated $C_1$ to $C_6$ alkyl, partially or perfluorinated $C_1$ to $C_6$ alkoxy, partially or perdeuterated $C_1$ to $C_6$ alkyl, partially or perdeuterated $C_1$ to $C_6$ alkoxy; halogen, CN or $PY(R^{10})_2$, wherein Y is selected from O, S or Se, and $R^{10}$ is independently selected from $C_6$ to $C_{12}$ aryl, $C_3$ to $C_{12}$ heteroaryl, $C_1$ to $C_6$ alkyl, $C_1$ to $C_6$ alkoxy, partially or perfluorinated $C_1$ to $C_6$ alkyl, partially or perfluorinated $C_1$ to $C_6$ alkoxy, partially or perdeuterated $C_1$ to $C_6$ alkyl, partially or perdeuterated $C_1$ to $C_6$ alkoxy. The one or more substituent(s) may be independently selected from the group consisting of D, $C_1$ to $C_6$ alkyl, $C_1$ to $C_6$ alkoxy, partially or perfluorinated $C_1$ to $C_6$ alkyl, partially or perfluorinated $C_1$ to $C_6$ alkoxy, partially or perdeuterated $C_1$ to $C_6$ alkyl, partially or perdeuterated $C_1$ to $C_6$ alkoxy. The one or more substituent(s) may be independently selected from the group consisting of D, $C_1$ to $C_6$ alkyl. The one or more substituent(s) may be independently D.

If A is substituted, the one or more substituent(s) are independently selected from the group consisting of D, $C_1$ to $C_6$ alkyl, $C_1$ to $C_6$ alkoxy, partially or perfluorinated $C_1$ to $C_6$ alkyl, partially or perfluorinated $C_1$ to $C_6$ alkoxy, partially or perdeuterated $C_1$ to $C_6$ alkyl, partially or perdeuterated $C_1$ to $C_6$ alkoxy.

If A is substituted, the one or more substituent(s) are independently selected from the group consisting of D, $C_1$ to $C_6$ alkyl.

If A is substituted, the one or more substituent(s) may be independently selected from the group consisting of D, methyl.

If A is substituted fluorenyl and the substituents are bonded to the $sp^3$ carbon of the 5-membered ring of the fluorenyl then the substituents may be independently selected from D, methyl and phenyl.

$R^2$ is a group of Formula (II)

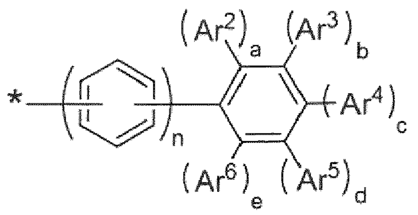

(II)

wherein * represents the binding position to the remaining structure of Formula (1).

That is, the group of formula (II) is bound to the remaining structure to form a structure of the formula

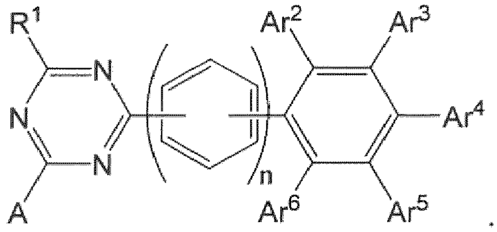

a, b, c, d, e are independently o or 1, wherein $1 \leq a+b+c+d+e \leq 5$. In terms of the present disclosure if one or more of a, b, c, d, and e is o, than the respective group $Ar^2$, $Ar^3$, $Ar^4$, $Ar^5$, and $Ar^6$ is not present, that is, not independently selected from the group consisting of substituted or unsubstituted $C_6$ to $C_{12}$ aryl and substituted or unsubstituted $C_4$ to $C_{10}$ heteroaryl but rather there is a H or D at the respective position, preferably H. E.g., in a situation where a=1, b=1, c=1; d=1 and e=o, the group of formula (II) may have the following formula

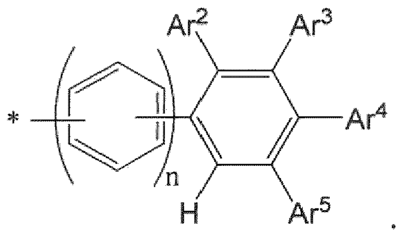

It may be provided that a, b, c, d, e are independently o or 1, wherein $1 \leq a+b+c+d+e \leq 4$. It may be provided that a, b, c, d, e are independently 0 or 1, wherein $2 \leq a+b+c+d+e \leq 4$.

It is preferred that

(1.) at least two adjacent of $Ar^2$ to $Ar^6$ are present, that is, the respective a to e are 1, and/or

(2.) at least one of $Ar^2$ and $Ar^6$ is present, that is, a and/or e is/are 1.

It is preferred that

(1.) at least two adjacent of $Ar^2$ to $Ar^6$ are present, that is, the respective a to e are 1, and/or

(2.) at least one of $Ar^2$ and $Ar^6$ is present, that is, a and/or e is/are 1; and

the compound of formula (1) has a LUMO from -2.1 eV to -1.8 eV.

In other words, it is preferred that

(1.) at least two of $Ar^2$ to $Ar^6$ are present and in ortho-position with respect to each other; and/or
(2.) at least one of $Ar^2$ and $Ar^6$ is present, that is, in ortho-position to the spacer

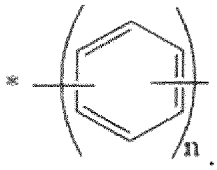

In still other words, it is preferred that at least one of the following is fulfilled: a=1; a=1 and b=1; b=1 and c=1; c=1 and d=1; d=1 and e=1; and e=1.

It is preferred that

a=1 and b=1 and c=1 and d=1;
or
b=1 and c=1 and d=1;
or
a=1 and c=1 and e=1;
or
a=1 and c=1 and d=1;
or
a=1 and e=1;
or
c=1 and d=1;
or
b=1 and d=1.

It is preferred that

a=1 and b=1 and c=1 and d=1;
or
b=1 and c=1 and d=1;
or
a=1 and c=1 and e=1;
or
a=1 and c=1 and d=1;
or
a=1 and e=1;
or
c=1 and d=1;
or
b=1 and d=1.

It is preferred that

a=1 and b=1 and c=1 and d=1;
or
b=1 and c=1 and d=1;
or
a=1 and c=1 and e=1;
or
a=1 and c=1 and d=1;
or
a=1 and e=1;

or
c=1 and d=1;
or
b=1 and d=1.

It is preferred that

a=1 and b=1 and c=1 and d=1;
or

b=1 and c=1 and d=1;
or

a=1 and c=1 and e=1;
or

a=1 and c=1 and d=1;
or

a=1 and e=1;
or

c=1 and d=1;
or

b=1 and d=1
and

the compound of formula (I) has a LUMO from -2.1 eV to -1.8 eV.

In formula (II), "n" is 0, 1, or 2. "n" may be 1 or 2.
$Ar^2$, $Ar^3$, $Ar^4$, $Ar^5$, and $Ar^6$ are independently selected from the group consisting of substituted or unsubstituted $C_6$ to $C_{12}$ aryl and substituted or unsubstituted $C_4$ to $C_{10}$ heteroaryl. $Ar^2$, $Ar^3$, $Ar^4$, $Ar^5$, and $Ar^6$ may be independently selected from the group consisting of substituted or unsubstituted $C_6$ to $C_{12}$ aryl. $Ar^2$, $Ar^3$, $Ar^4$, $Ar^5$, and $Ar^6$ may be independently selected from the group consisting of substituted or unsubstituted $C_6$ to $C_{10}$ aryl. $Ar^2$, $Ar^3$, $Ar^4$, $Ar^5$, and $Ar^6$ may be independently selected from the group consisting of substituted or unsubstituted phenyl. $Ar^2$, $Ar^3$, $Ar^4$, $Ar^5$, and $Ar^6$ may be each phenyl.
If one or more of $Ar^2$, $Ar^3$, $Ar^4$, $Ar^5$, and $Ar^6$ is substituted, the one or more substituent(s) are independently selected from the group consisting of D, $C_1$ to $C_6$ alkyl, $C_1$ to $C_6$ alkoxy, partially or perdeuterated $C_1$ to $C_6$ alkyl, partially or perdeuterated $C_1$ to $C_6$ alkoxy, partially or perfluorinated $C_1$ to $C_6$ alkyl, partially or perfluorinated $C_1$ to $C_6$ alkoxy, F, and CN. The one or more substituent(s) may be independently selected from the group consisting of D, $C_1$ to $C_6$ alkyl, $C_1$ to $C_6$ alkoxy, partially or perdeuterated $C_1$ to $C_6$ alkyl, partially or perdeuterated $C_1$ to $C_6$ alkoxy, partially or perfluorinated $C_1$ to $C_6$ alkyl, partially or perfluorinated $C_1$ to $C_6$ alkoxy. The one or more substituent(s) may be independently selected from the group consisting of D, $C_1$ to $C_6$ alkyl. The one or more substituent(s) may be independently D.
The compound of formula (I) may have a LUMO from -2.1 eV to -1.8 eV, preferred -2.0 eV to -1.9 eV, further preferred -1.97 eV to -1.9 eV.
According to the present disclosure, the HOMO and LUMO are calculated with the program package ORCA V5.0.3 (Max Planck Institute für Kohlenforschung, Kaiser Wilhelm Platz 1, 45470, Muelheim/Ruhr, Germany) and WEASEL 1.9.2 (FAccTs GmbH, Rolandstrasse 67, 50677 Köln, Germany) The optimized geometries and the HOMO and LUMO energy levels of the molecular structures are determined by applying the hybrid functional B3LYP with a 6-31G* basis set in the gas phase. If more than one conformation is viable, the conformation with the lowest total energy is selected.
The dipole moment of the compound of Formula (I) is $\geq 0$ D and $\leq 1$ D.
The dipole moment $|\vec{\mu}|$ of a molecule containing N atoms is given by:

$$\vec{\mu} = \sum_{i}^{N} q_i \vec{r_i}$$

$$|\vec{\mu}| = \sqrt{\mu_x^2 + \mu_y^2 + \mu_z^2}$$

where $q_i$ and $\vec{r_i}$ are the partial charge and position of atom i in the molecule.

The dipole moment is determined by a semi-empirical molecular orbital method.

The geometries of the molecular structures are optimized using the hybrid functional B3LYP with the 6-31G* basis set in the gas phase as implemented in the program package ORCA V5.0.3 (Max Planck Institute für Kohlenforschung, Kaiser Wilhelm Platz 1, 45470, Muelheim/Ruhr, Germany) and WEASEL 1.9.2 (FAccTs GmbH, Rolandstrasse 67, 50677 Köln, Germany). If more than one conformation is viable, the conformation with the lowest total energy is selected to determine the bond lengths of the molecules.

A is chosen so that the dipole moment of a compound "A-phenyl" is ≥ 0 D and ≤ 1 D. Especially, A is chosen so that the dipole moment, computed by the TURBOMOLE V6.5 program package using hybrid functional B3LYP and Gaussian 6-31G* basis set, of a compound A-phenyl is ≥ 0 D and ≤ 1 D. The unit for the dipole moment "Debye" is abbreviated with the symbol "D". The inventors have found that it is advantageous if the compound of Formula (I) comprises a group having a certain polarity, that is a specific dipole moment within the above range or the ranges mentioned below. It was further found that it is still advantageous that the compound of Formula (I) comprises such a rather unpolar group (first polar group) if the compound of Formula (I) comprises, in addition, a further rather unpolar group (second polar group) which is suitable to balance the dipole moment of the first polar group in a way that the total dipole moment of the compound of Formula (II) is low, for example, in case that the compound is a symmetrical molecule comprising a first unpolar group and a second unpolar group which are the same, the dipole moment could be 0 Debye. Therefore, the compound of Formula (I) cannot be characterized completely by referring to the total dipole moment of the compound only. As a consequence, reference is made instead to an artificial compound comprising the rather unpolar group "A" and an unpolar group "phenyl". If more than one conformational isomer of the compound A-phenyl is viable then the average value of the dipole moments of the conformational isomers of A-phenyl is selected to be in this range. Conformational isomerism is a form of stereoisomerism in which the isomers can be interconverted just by rotations about formally single bonds.

A may be chosen so that the dipole moment of a compound "A-phenyl" is ≥ 0 D and < 1 D.

Examplary compounds "A-phenyl" in accordance with the invention and the respective dipole moment are as follows:

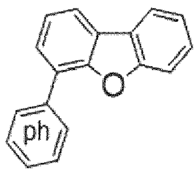 0.57 D; 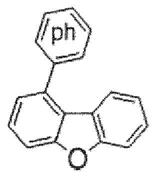 0.98 D; 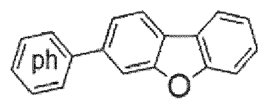 0.69 D;

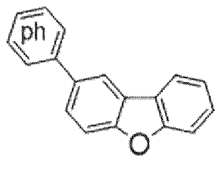 0.68 D; 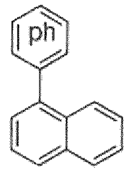 0.17 D; 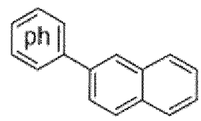 0.02.

the compound of Formula (I) may be selected from ET-1 to ET-15

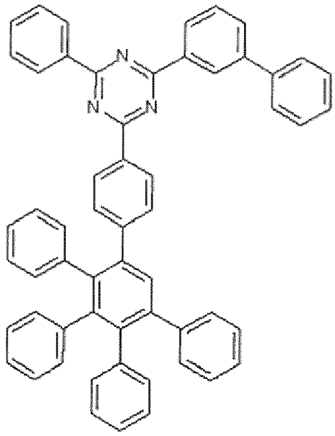

ET-1

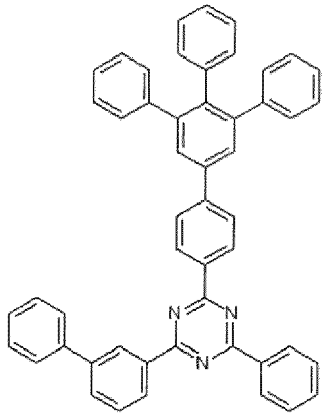

ET-2

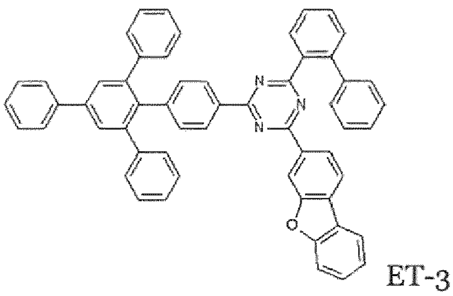

ET-3

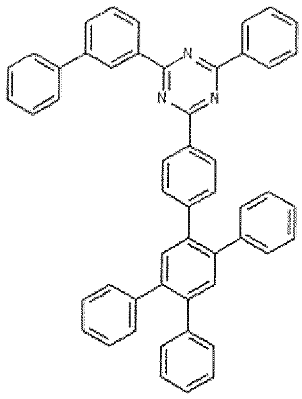

ET-4

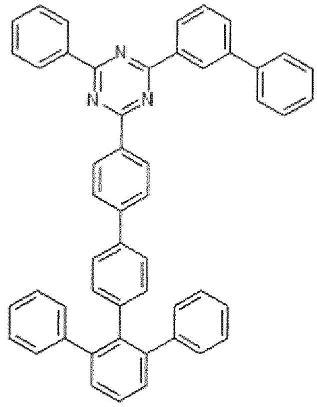

ET-5

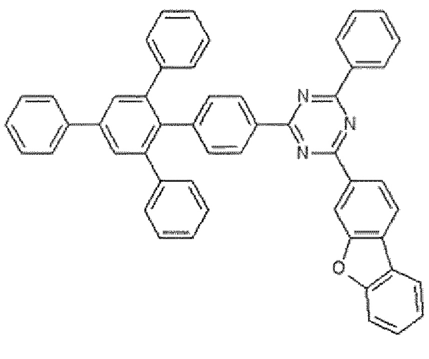

ET-6

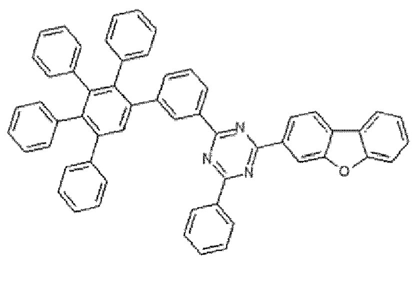

ET-7

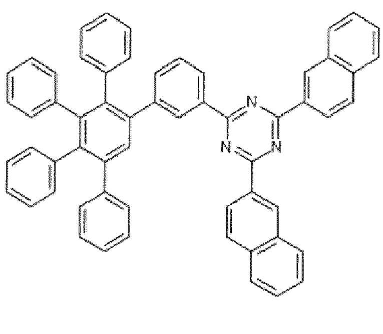

ET-8

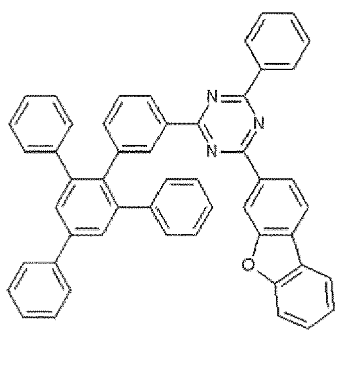

ET-9

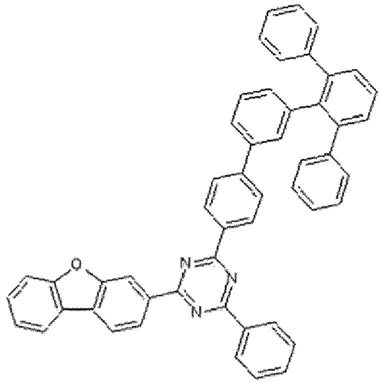

ET-10

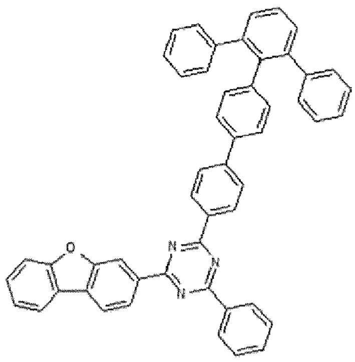

ET-11

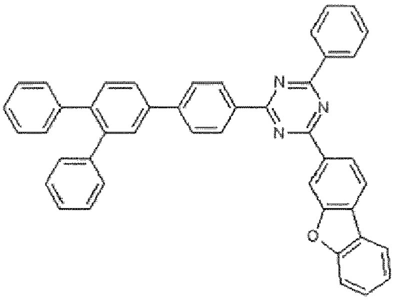

ET-12

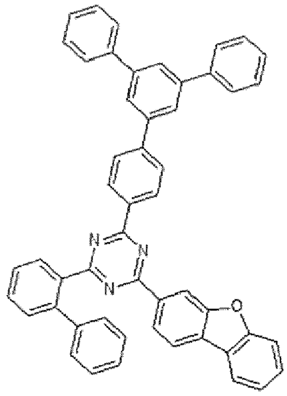

ET-13

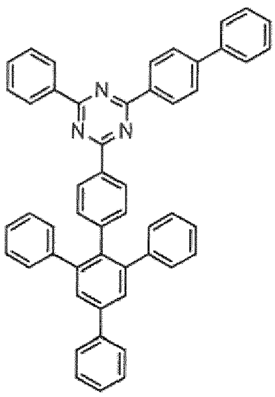

ET-14

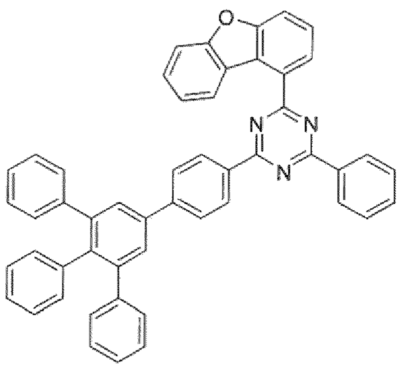

ET-15

It may be provided that the compound of formula (I) does not have the following formula

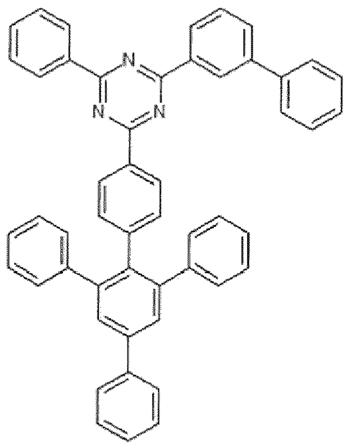

It may be provided that in the compound of formula (I), if A=$C_{12}$ aryl and n=1 or 2, then a+c+e=0 to 2.

Compound aET

The organic light emitting diode according to the invention may further comprise an auxiliary electron transport layer. If present, the auxiliary electron transport layer is arranged between the first emission layer and the second emission layer and comprises a compound aET.

The LUMO energy level of the compound aET in the absolute scale taking vacuum energy level as zero, computed by the TURBOMOLE V6.5 program package using hybrid functional B3LYP and Gaussian 6-31G* basis set, is in the range from -1.90 eV to -1.50 eV, preferably from -1.85 eV to -1.55 eV, preferably from -1.83 eV to -1.58 eV. This may be the compound of formula (III) as defined herein.

The organic light emitting diode according to the invention may further comprise an auxiliary electron transport layer. If present, the auxiliary electron transport layer is arranged between the first emission layer and the second emission layer and comprises a compound aET and the compound aET is a compound of Formula (III)

$$(Ar^1\text{-}R^3{}_p)_q\text{-}X_r \qquad \text{(III)}.$$

In the compound of Formula (III), the group "$R^3$" is a spacer moiety connecting (if present, that is in case that p > 1) the group $Ar^1$ and X. In case that the compound of Formula (III) comprises more than one groups ($Ar^1$-$R^3{}_p$), the groups may or may not independently comprise the spacer $R^3$.

In the compound of Formula (III), q and r are independently 1 or 2. Alternatively, q and r may both be 1.

In the compound of Formula (I), p is independently 0 or 1.

$Ar^1$ is independently selected from $C_6$ to $C_{60}$ aryl or $C_2$ to $C_{42}$ heteroaryl, alternatively $C_6$ to $C_{54}$ aryl or $C_2$ to $C_{39}$ heteroaryl, alternatively $C_6$ to $C_{48}$ aryl or $C_2$ to $C_{36}$ heteroaryl, alternatively $C_6$ to $C_{42}$ aryl or $C_2$ to $C_{36}$ heteroaryl, alternatively $C_6$ to $C_{36}$ aryl or $C_2$ to $C_{30}$ heteroaryl, alternatively $C_6$ to $C_{30}$ aryl or $C_2$ to $C_{24}$ heteroaryl.

$Ar^1$ may be independently $C_6$ to $C_{54}$ aryl, optionally $C_6$ to $C_{48}$ aryl, optionally $C_6$ to $C_{42}$ aryl, optionally $C_6$ to $C_{36}$ aryl, optionally $C_6$ to $C_{30}$ aryl, and optionally $C_6$ to $C_{24}$ aryl.

$Ar^1$ may be independently $C_2$ to $C_{42}$ hetroaryl, optionally $C_2$ to $C_{40}$ hetroaryl, optionally $C_2$ to $C_{36}$ hetroaryl, optionally $C_2$ to $C_{30}$ hetroaryl, and optionally $C_2$ to $C_{24}$ hetroaryl.

$Ar^1$ may be independently $C_6$ to $C_{54}$ aryl, optionally $C_6$ to $C_{48}$ aryl, optionally $C_6$ to $C_{42}$ aryl, optionally $C_6$ to $C_{36}$ aryl, optionally $C_6$ to $C_{30}$ aryl, and optionally $C_6$ to $C_{24}$ aryl.

$Ar^1$ may be independently $C_2$ to $C_{42}$ hetroaryl, optionally $C_2$ to $C_{40}$ hetroaryl, optionally $C_2$ to $C_{36}$ hetroaryl, optionally $C_2$ to $C_{30}$ hetroaryl, and optionally $C_2$ to $C_{24}$ hetroaryl.

In an embodiment where $Ar^1$ is independently selected from unsubstituted $C_2$ to $C_{42}$ heteroaryl, the heteroatoms are bound into the molecular structure of $Ar^1$ by single bonds.

$Ar^1$ may be independently selected from the group consisting of phenyl, naphthyl, anthracenyl, fluoranthenyl, xanthenyl, spiro-xanthenyl, fluorenyl, spiro-fluorenyl, triphenylsilyl, tetraphenylsilyl, dibenzo-furanyl, di-dibenzofuranyl, pyrimidinyl, pyrazinyl, aryl- alkenyl, a group having the formula (IIIa) and a group having the formula (IIIb)

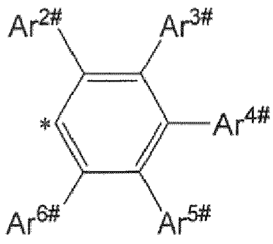

(IIIa)

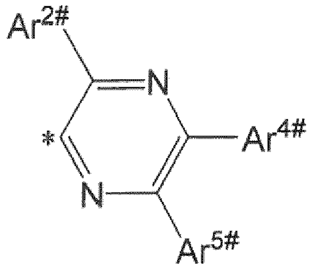

(IIIb)

wherein

- * represents the binding position for binding the group of formula (IIIa) or (IIIb) to $R^3$; and
- $Ar^{2\#}$ to $Ar^{6\#}$ are independently selected from the group consisting of H, $C_6$ to $C_{15}$ aryl and $C_3$ to $C_{12}$.

$Ar^1$ may be independently selected from the group consisting of a group having the formula (IIIa) and a group having the formula (IIIb)

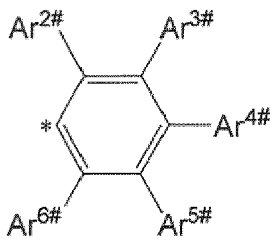

(IIIa)

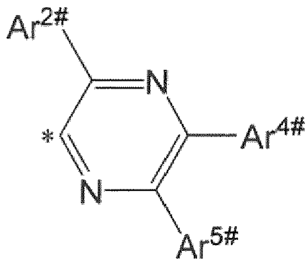

(IIIb)

wherein

- * represents the binding position for binding the group of formula (IIIa) or (IIIb) to $R^3$; and
- $Ar^{2\#}$ to $Ar^{6\#}$ are independently selected from the group consisting of H, $C_6$ to $C_{15}$ aryl and $C_3$ to $C_{12}$ heteroaryl.

$Ar^1$ may be independently selected from the group consisting of a group having the formula (IIIa) and a group having the formula (IIIb)

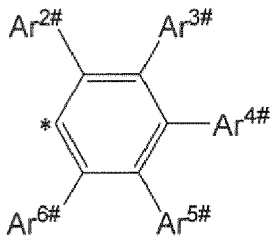

(IIIa)

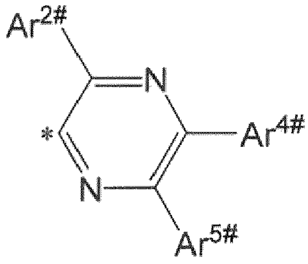

(IIIb)

wherein

- * represents the binding position for binding the group of formula (IIIa) or (IIIb) to $R^3$; and
- $Ar^{2\#}$ to $Ar^{6\#}$ are independently selected from the group consisting of H, $C_6$ to $C_{15}$ aryl and Si-containing $C_3$ to $C_{12}$ heteroaryl.

In case that $Ar^1$ is substituted, each of the substituents may be independently selected from the group consisting of D and $C_1$ to $C_6$ alkyl, preferably D and methyl.

$Ar^1$ may be independently selected from the group consisting of a group having the formula (IIIa) and a group having the formula (IIIb)

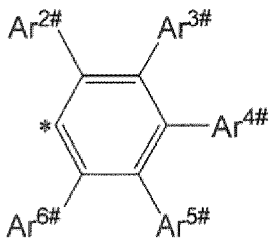

(IIIa)

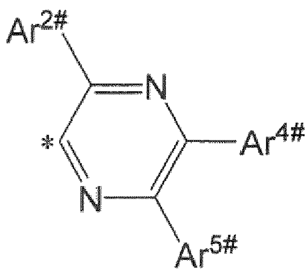

(IIIb)

wherein

- * represents the binding position for binding the group of formula (IIIa) or (IIIb) to $R^3$; and
- $Ar^{2\#}$ to $Ar^{6\#}$ (including all substituents) are independently selected from the group consisting of H, phenyl

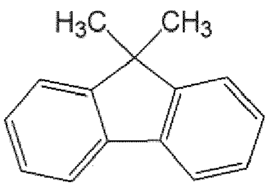
and
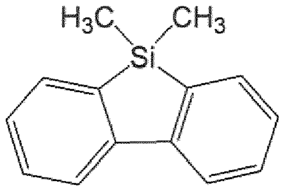
.

In the group of Formula (IIIa), at least two of $Ar^{2\#}$ to $Ar^{6\#}$ which are not H may be in ortho-position to each other. At least one of $Ar^{2\#}$ to $Ar^{6\#}$ which is not H may be in ortho-position to the *-position. In this regard, two groups are in ortho position to each other if bound to adjacent carbon atoms of the benzene ring in Formula (IIIa), respectively.

Preferred $Ar^1$ (including all substituents) may be selected independently from one of the following groups

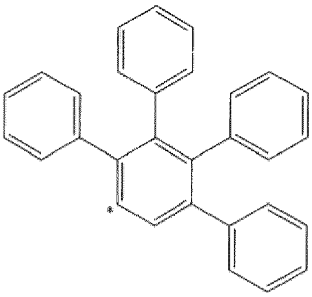
;
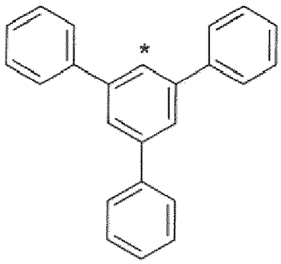
;
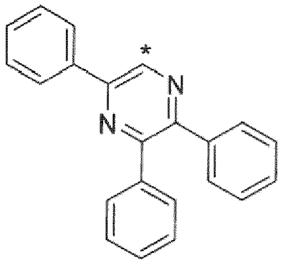
;
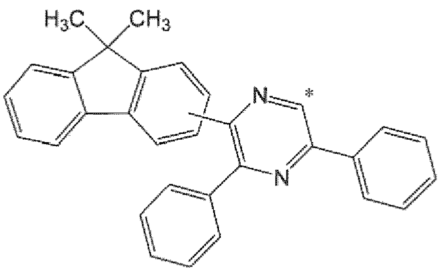
;
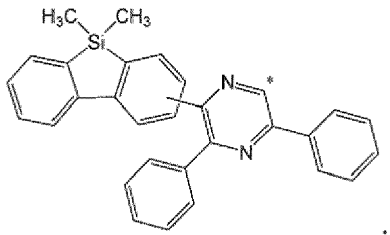
.

Preferred $Ar^1$ (including all substituents) may be selected independently from one of the following groups

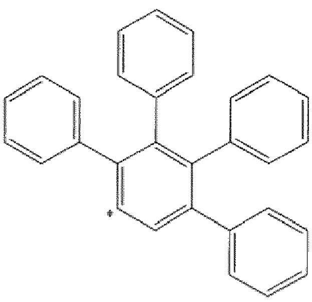
;
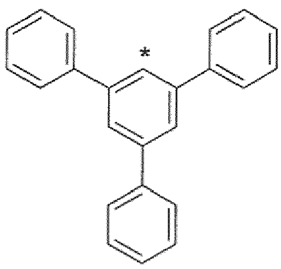
;
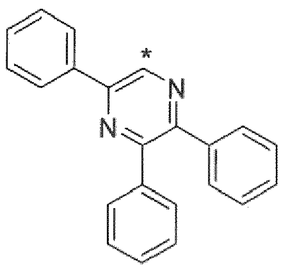
;
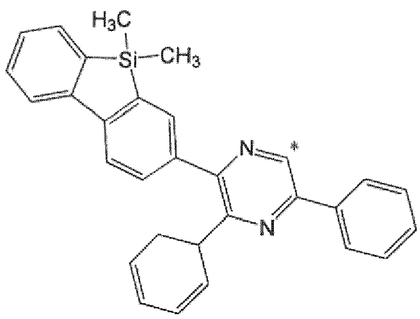
;
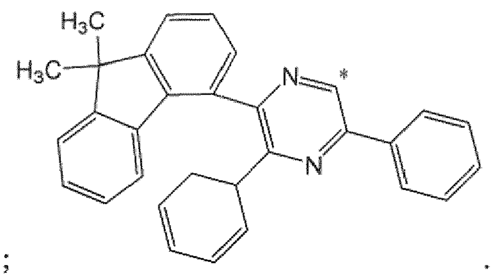
.

$R_3$ may be independently selected from substituted or unsubstituted $C_6$ to $C_{30}$ aryl, alternatively $C_6$ to $C_{24}$ aryl, alternatively $C_6$ to $C_{18}$ aryl.

$R_3$ may be selected independently from the group consisting of phenylene, naphthylene, biphenylene and terphenylene which may be substituted or unsubstituted, respectively.

$R_3$ may be selected independently from one of the following groups or combinations thereof

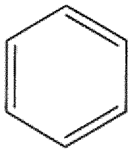 ; 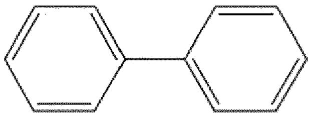 ; 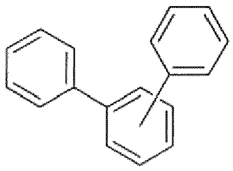 ; 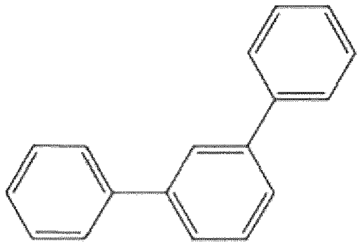

wherein the binding positions for binding to $Ar^1$ and X can be freely selected, preferably

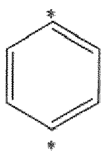 ; 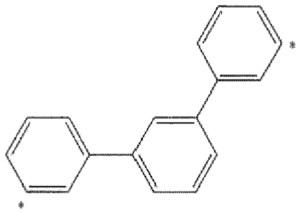 ; 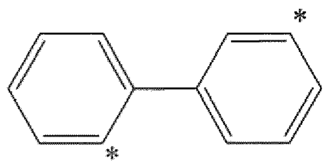 ; 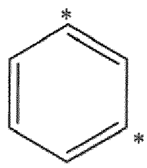 .

If $R^3$ is substituted $C_6$ to $C_{30}$ aryl the one or more substituent(s) may be independently selected from the group consisting of D, $C_1$ to $C_6$ alkyl, $C_1$ to $C_6$ alkoxy, partially or perfluorinated $C_1$ to $C_6$ alkyl, partially or perfluorinated $C_1$ to $C_6$ alkoxy, partially or perdeuterated $C_1$ to $C_6$ alkyl, partially or perdeuterated $C_1$ to $C_6$ alkoxy; $C_6$ to $C_{12}$ aryl, $C_3$ to $C_{11}$ heteroaryl, halogen, CN or $PY(R^{10})_2$, wherein Y is selected from O, S or Se, and $R^{10}$ is independently selected from $C_6$ to $C_{12}$ aryl, $C_3$ to $C_{12}$ heteroaryl, $C_1$ to $C_6$ alkyl, $C_1$ to $C_6$ alkoxy, partially or perfluorinated $C_1$ to $C_6$ alkyl, partially or perfluorinated $C_1$ to $C_6$ alkoxy, partially or perdeuterated $C_1$ to $C_6$ alkyl, partially or perdeuterated $C_1$ to $C_6$ alkoxy,

- wherein each $C_6$ to $C_{12}$ aryl substituent on $Ar^1$ and each $C_3$ to $C_{11}$ heteroaryl substituent on $Ar^1$ may be substituted with one or more selected from $C_1$ to $C_4$ alkyl or halogen.

In case that $R_3$ is substituted, each substituent on $R_3$ may be independently selected from the group consisting of phenyl and $C_1$ to $C_4$ alkyl.

X may be independently selected from the group consisting of $C_2$ to $C_{39}$ heteroaryl and $C_6$ to $C_{54}$ aryl, optionally $C_2$ to $C_{36}$ heteroaryl and $C_6$ to $C_{48}$ aryl, optionally $C_3$ to $C_{30}$ heteroaryl and $C_6$ to $C_{42}$ aryl, optionally $C_3$ to $C_{27}$ heteroaryl and $C_6$ to $C_{36}$ aryl, optionally $C_3$ to $C_{24}$ heteroaryl and $C_6$ to $C_{30}$ aryl, and optionally $C_3$ to $C_{21}$ heteroaryl and $C_6$ to $C_{24}$ aryl, wherein the respective group may be substituted or unsubstituted.

X may be independently selected from the group consisting of $C_2$ to $C_{39}$ N-containing heteroaryl, $C_2$ to $C_{39}$ O-containing heteroaryl and $C_6$ to $C_{54}$ aryl, optionally $C_2$ to $C_{36}$ N-containing heteroaryl, $C_2$ to $C_{36}$ O-containing heteroaryl and $C_6$ to $C_{48}$ aryl, optionally $C_3$ to $C_{30}$ N-containing heteroaryl, $C_3$ to $C_{30}$ O-containing heteroaryl and $C_6$ to $C_{42}$ aryl, optionally $C_3$ to $C_{27}$ N-containing heteroaryl, $C_3$ to $C_{27}$ 0-containing heteroaryl and $C_6$ to $C_{36}$ aryl, optionally $C_3$ to $C_{24}$ N-containing heteroaryl, $C_3$ to $C_{24}$ O-containing heteroaryl and $C_6$ to $C_{30}$ aryl, and optionally $C_3$ to $C_{21}$ N-containing heteroaryl, $C_3$ to $C_{21}$ O-containing heteroaryl and $C_6$ to $C_{24}$ aryl.

X may be independently selected from the group consisting of $C_2$ to $C_{39}$ N-containing heteroaryl and $C_6$ to $C_{54}$ aryl, optionally $C_2$ to $C_{36}$ N-containing heteroaryl, and $C_6$ to $C_{48}$ aryl, optionally $C_3$ to $C_{30}$ N-containing heteroaryl and $C_6$ to $C_{42}$ aryl, optionally $C_3$ to $C_{17}$ N-containing heteroaryl and $C_6$ to $C_{36}$ aryl, optionally $C_3$ to $C_{24}$ N-containing heteroaryl and $C_6$ to $C_{30}$ aryl, and optionally $C_3$ to $C_{21}$ N-containing heteroaryl and $C_6$ to $C_{24}$ aryl. In this regard, it may be provided that a respective N-containing heteroaryl comprises one or more N-atoms as the only heteroatom(s).

X may be independently selected from the group consisting of triazinyl, 1,2-diazinyl, 1,3-diazinyl, 1,4-diazinyl, quinazolinyl, benzoquinazolinyl, benzimidazolyl, quinolinyl, benzoquinolinyl benzoacridinyl, dibenzoacridinyl, fluoranthenyl, anthracenyl, naphthyl, triphenylenyl, phenathrolinyl, and dinaphthofuranyl which may be substituted or unsubstituted, respectively.

X may be independently selected from the group consisting of triazinyl, 1,2-diazinyl, 1,3-diazinyl, 1,4-diazinyl,

quinazolinyl, benzoquinazolinyl, benzoacridinyl, dibenzoacridinyl, fluoranthenyl, anthracenyl, naphthyl, triphenylenyl, phenathrolinyl, and dinaphthofuranyl which may be substituted or unsubstituted, respectively.

X may be independently selected from the group consisting of triazinyl, and 1,3-diazinyl which may be substituted or unsubstituted, respectively.

If X is substituted $C_2$ to $C_{42}$ heteroaryl or substituted $C_6$ to $C_{60}$ aryl the one or more substituent(s) are independently selected from the group consisting of D, $C_1$ to $C_6$ alkyl, $C_1$ to $C_6$ alkoxy, partially or perfluorinated $C_1$ to $C_6$ alkyl, partially or perfluorinated $C_1$ to $C_6$ alkoxy, partially or perdeuterated $C_1$ to $C_6$ alkyl, partially or perdeuterated $C_1$ to $C_6$ alkoxy; $C_6$ to $C_{12}$ aryl, $C_3$ to $C_{11}$ heteroaryl, halogen, CN or $PY(R^{10})_2$, wherein Y is selected from O, S or Se, and $R_{10}$ is independently selected from $C_6$ to $C_{12}$ aryl, $C_3$ to $C_{12}$ heteroaryl, $C_1$ to $C_6$ alkyl, $C_1$ to $C_6$ alkoxy, partially or perfluorinated $C_1$ to $C_6$ alkyl, partially or perfluorinated $C_1$ to $C_6$ alkoxy, partially or perdeuterated $C_1$ to $C_6$ alkyl, partially or perdeuterated $C_1$ to $C_6$ alkoxy,

- wherein each $C_6$ to $C_{12}$ aryl substituent on $Ar^1$ and each $C_3$ to $C_{11}$ heteroaryl substituent on $Ar^1$ may be substituted with one or more selected from $C_1$ to $C_4$ alkyl or halogen.

In case that X is substituted, each substituent on X may be independently selected from the group consisting of $C_6$ to $C_{15}$ aryl and $C_3$ to $C_{14}$ heteroaryl which may be substituted with D or $C_1$ to $C_4$ alkyl, respectively. In case that X is substituted, each substituent on X may be independently selected from the group consisting of phenyl, biphenyl-yl, 9,9-dimethylfluorene and

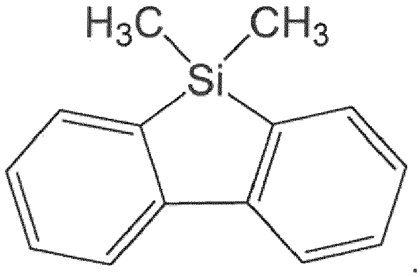

In case that X is substituted, each substituent on X may be independently selected from the group consisting of phenyl, biphenyl-yl, and

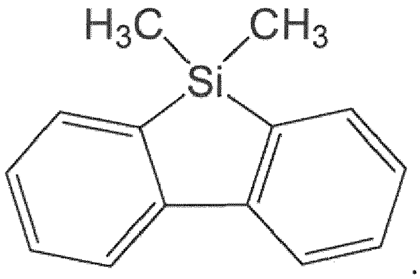

In case that X is substituted, each substituent on X may be independently selected from the group consisting of phenyl, biphenyl-yl. In case that X is substituted, each substituent on X may be phenyl.

In case that X is substituted, respective substituted X groups may be

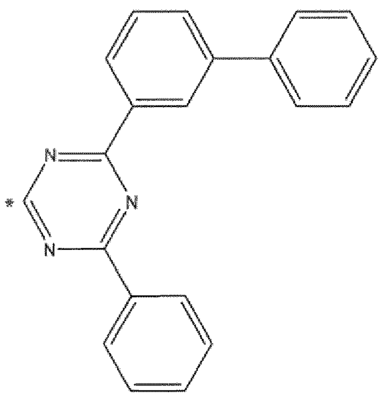;
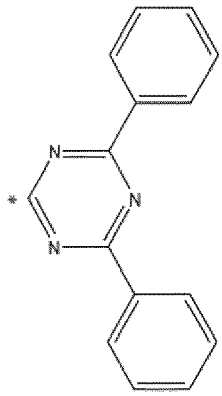;
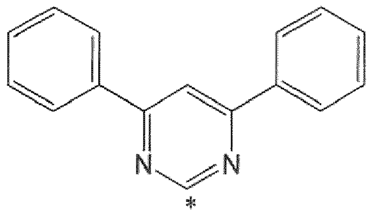;

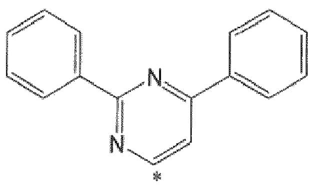;
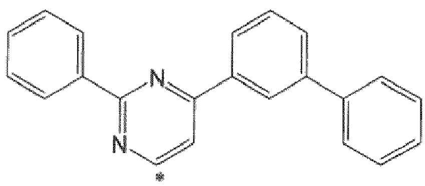;
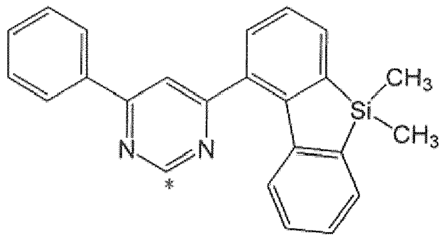

wherein the asterisk symbol "*" represents the binding position for binding the group to $R^3$, respectively.

It may be provided that the compound of Formula (III) does not contain a moiety P=O. It may be provided that the compound of Formula (III) does not contain $P(=O)Aryl_2$. It may be provided that the compound of Formula (III) does not contain $P(=O)Alkyl_2$. It may be provided that the compound of Formula (III) does not contain $P(=O)Ph_2$. It may be provided that the compound of Formula (III) does not contain $P(=O)(CH_3)_2$. It may be provided that the compound of Formula (III) does not contain R'P(=O)R" wherein R' and R" are connected with each other to form a ring, that is, does not contain ring-phosphine oxide. It may be provided that the compound of Formula (III) does not contain R'P(=O)R" wherein R' and R" are connected with each other to form a 7-membered ring.

It may be provided that the compound of Formula (III) does not contain two moieties P=O. It may be provided that wherein the compound of Formula (III) does not contain two $P(=O)Aryl_2$. It may be provided that wherein the compound of Formula (III) does not contain two $P(=O)Alkyl_2$. It may be provided that wherein the compound of Formula (III) does not contain two $P(=O)Ph_2$. It may be provided that wherein the compound of Formula (III) does not contain two $P(=O)(CH_3)_2$. It may be provided that wherein the compound of Formula (III) does not contain CN.

It may be provided that one or more of the following formulas are excluded from the scope of the Compound of Formula (III)

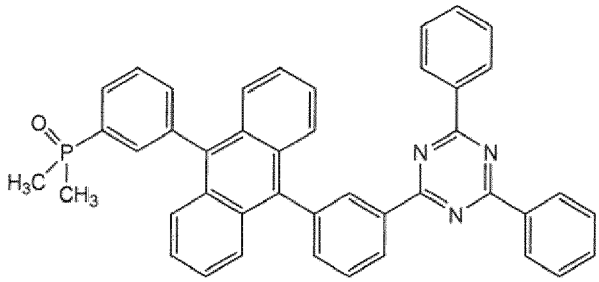;
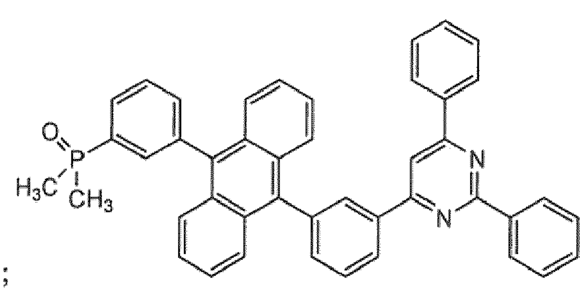;

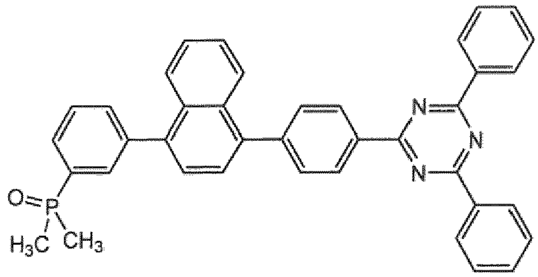
;
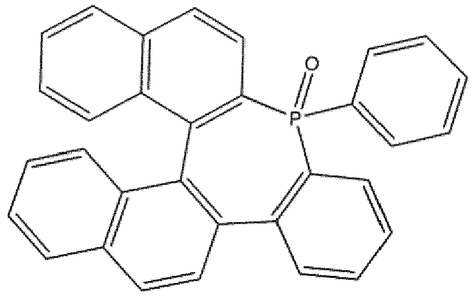
;
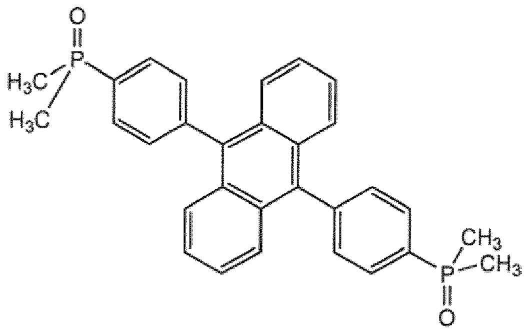
;
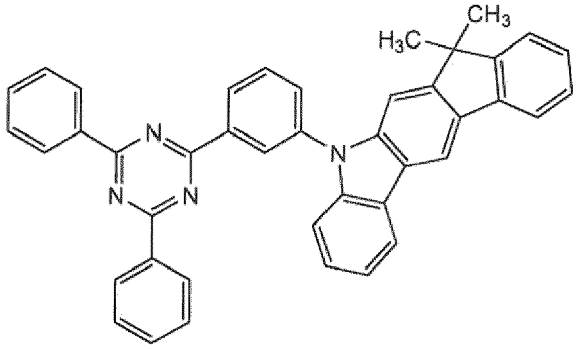
;
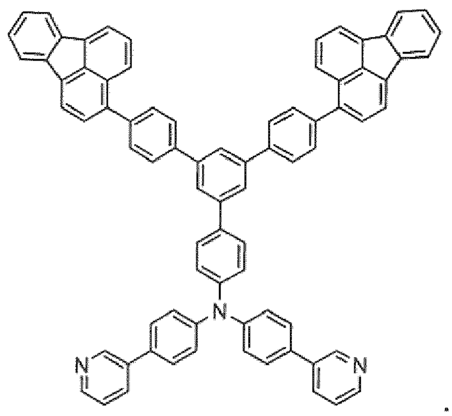
.

The compound of Formula (III) may comprise 6 to 14 aromatic or heteroaromatic rings, optionally 7 to 13 aromatic or heteroaromatic rings, optionally 7 to 12 aromatic or heteroaromatic rings, optionally 9 to 11 aromatic or heteroaromatic rings. In this regard, an aromatic, respectively heteroaromatic ring, is a single aromatic ring, for example a 6-membered aromatic ring such as phenyl, a 6-membered heteroaromatic ring, an example would be pyridyl, a 5-membered heteroaromatic ring an example would be pyrrolyl etc. In a system of condensed (hetero)aromatic rings, each ring is considered as a single ring in this regard. For example, naphthalene comprises two aromatic rings.

The molecular dipole moment of the compound of formula (III) is ≥ 0 D and ≤ 4 D. In an embodiment the molecular dipole moment of the compound of formula (III) is ≥ 0 D and ≤ 3 D.

The compound of aET may be selected from aET-1 to aET-9

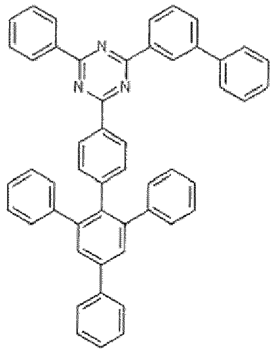
aET-1

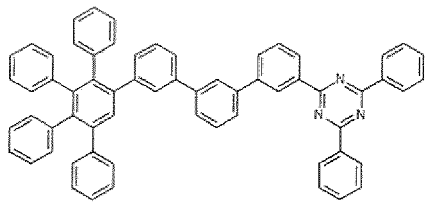
aET-2

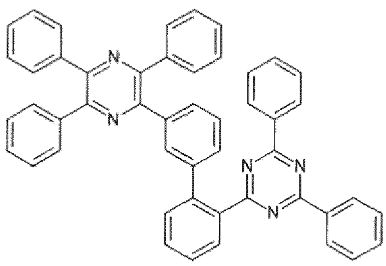
aET-3

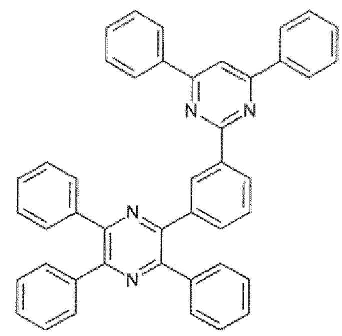
aET-4

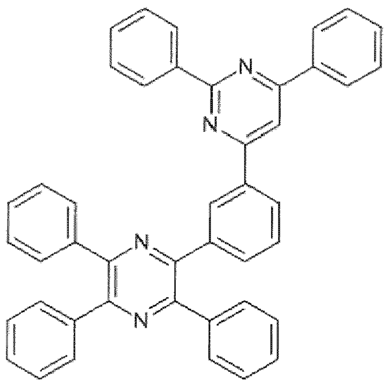
aET-5

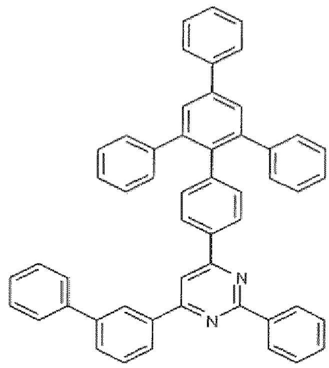
aET-6

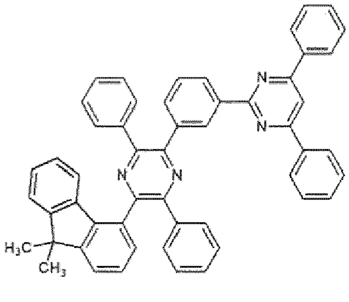
aET-7

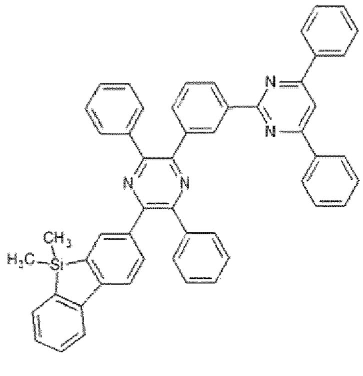
aET-8

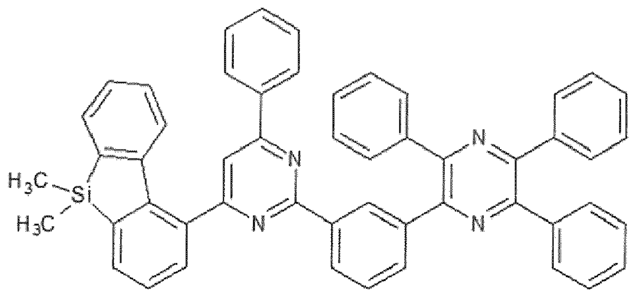

aET-9.

Heterocyclic compound nCG

The heterocyclic compound in the n-type charge generation layer, herein referred to as "heterocyclic compound nCG" comprises at least one five-membered ring comprising at least one N-atom and/or at least one six-membered ring comprising at least one N-atom.

The heterocyclic compound nCG may comprise at least one moiety selected from the group consisting of bipyridine, terpyridine, phenanthroline, pyridine-imidazo-pyridine, pyridine-benzimidazole.

The heterocyclic compound nCG may comprise at least two moieties selected from the group consisting of bipyridine, terpyridine, phenanthroline, pyridine-imidazo-pyridine, pyridine-benzimidazole.

The heterocyclic compound nCG may comprise at least one moiety selected from the group consisting of bipyridine, 1,10-phenanthroline, pyridine-benzimidazole.

The heterocyclic compound nCG may comprise at least two moieties selected from the group consisting of bipyridine, 1,10-phenanthroline, pyridine-benzimidazole.

The heterocyclic compound nCG may have the following formula (IV)

$$CG^1\text{-}R^4\text{-}CG^2 \qquad (IV)$$

wherein

$CG^1$ is selected from groups comprising at least one five-membered ring comprising at least one N-atom and/or at least one six-membered ring comprising at least one N-atom;

$CG^2$ is selected from the group consisting of substituted or unsubstituted $C_{14}$ to $C_{60}$ aryl and $C_3$ to $C_{60}$ heteroaryl; and

$R^3$ is independently selected from a single bond or substituted or unsubstituted $C_6$ to $C_{30}$ aryl.

$CG^1$ may be selected from substituted or unsubstituted $C_3$ to $C_{60}$ heteroaryl comprising at least one five-membered ring comprising at least one N-atom and/or at least one six-membered ring comprising at least one N-atom. $CG^1$ may be selected from substituted or unsubstituted $C_3$ to $C_{54}$ heteroaryl comprising at least one five-membered ring comprising at least one N-atom and/or at least one six-membered ring comprising at least one N-atom. $CG^1$ a may be selected from substituted or unsubstituted $C_3$ to $C_{48}$ heteroaryl comprising at least one five-membered ring comprising at least one N-atom and/or at least one six-membered ring comprising at least one N-atom. $CG^1$ may be independently selected from substituted or unsubstituted $C_3$ to $C_{42}$ heteroaryl comprising at least one five-membered ring comprising at least one N-atom and/or at least one six-membered ring comprising at least one N-atom. $CG^1$ may be selected from substituted or unsubstituted $C_3$ to $C_{36}$ heteroaryl comprising at least one five-membered ring comprising at least one N-atom and/or at least one six-membered ring comprising at least one N-atom. $CG^1$ may be selected from substituted or unsubstituted $C_3$ to $C_{30}$ heteroaryl comprising at least one five-membered ring comprising at least one N-atom and/or at least one six-membered ring comprising at least one N-atom. $CG^1$ may be selected from substituted or unsubstituted $C_3$ to $C_{24}$ heteroaryl comprising at least one five-membered ring comprising at least one N-atom and/or at least one six-membered ring comprising at least one N-atom. $CG^1$ may be selected from substituted or unsubstituted $C_5$ to $C_{21}$ heteroaryl comprising at least one five-membered ring comprising at least one N-atom and/or at least one six-membered ring comprising at least one N-atom. $CG^1$ may be selected from substituted or unsubstituted $C_{10}$ to $C_{12}$ heteroaryl comprising at least one five-membered ring comprising at least one N-atom and/or at least one six-membered ring comprising at least one N-atom.

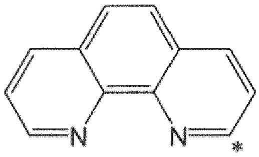 ; 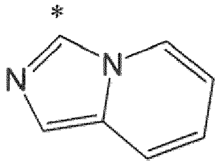 ; 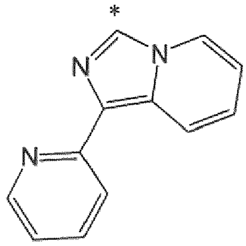 ; 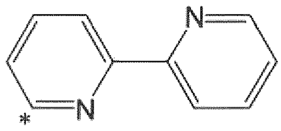 ;

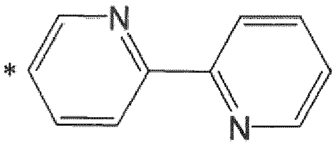 ; 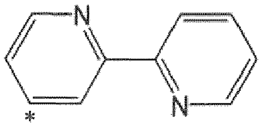 ; 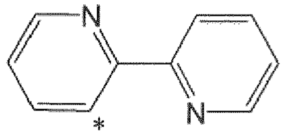 ;

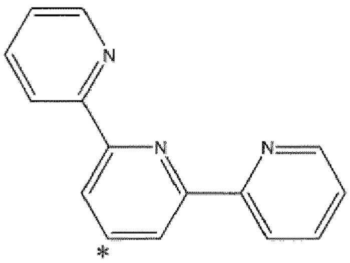

wherein * represents the binding position to $R^4$.

$CG^1$ (including all substituents) may be independently selected from

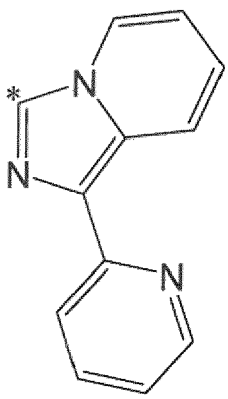 ; 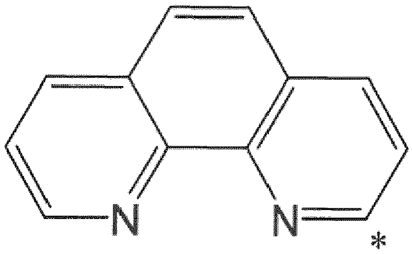 ; 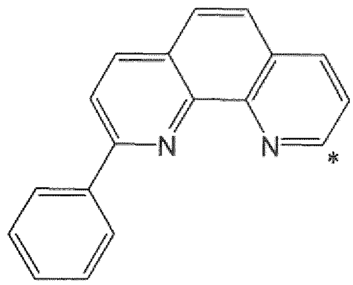

wherein * indicates the binding position to $R^4$.

$CG^2$ may be selected from the group consisting of substituted or unsubstituted $C_{14}$ to $C_{60}$ aryl and $C_3$ to $C_{60}$ heteroaryl. $CG^2$ may be selected from the group consisting of substituted or unsubstituted $C_{14}$ to $C_{54}$ aryl and $C_3$ to $C_{54}$ heteroaryl. $CG^2$ may be selected from the group consisting of substituted or unsubstituted $C_{14}$ to $C_{48}$ aryl and $C_3$ to $C_{48}$ heteroaryl. $CG^2$ may be selected from the group consisting of substituted or unsubstituted $C_{14}$ to $C_{42}$ aryl and $C_3$ to $C_{42}$ heteroaryl. $CG^2$ may be selected from the group consisting of substituted or unsubstituted $C_{14}$ to $C_{36}$ aryl and $C_3$ to $C_{36}$ heteroaryl. $CG^2$ may be selected from the group consisting of substituted or unsubstituted $C_{14}$ to $C_{30}$ aryl and $C_3$ to $C_{30}$ heteroaryl. $CG^2$ may be selected from the group consisting of substituted or unsubstituted $C_{14}$ to $C_{24}$ aryl and $C_3$ to $C_{24}$ heteroaryl. $CG^2$ may be selected from the group consisting of substituted or unsubstituted $C_{14}$ to $C_{18}$ aryl and $C_3$ to $C_{18}$ heteroaryl.

$R^4$ is independently selected from a single bond or substituted or unsubstituted $C_6$ to $C_{30}$ aryl, alternatively a single bond or $C_6$ to $C_{24}$ aryl, alternatively a single bond or $C_6$ to $C_{18}$ aryl.

$R^4$ may be selected independently from the group consisting of a single bond, phenylene, naphthylene, biphenylene and terphenylene which may be substituted or unsubstituted, respectively.

$R^4$ may be a single bond or selected independently from one of the following groups or combinations thereof

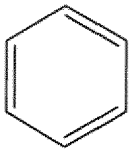 ; 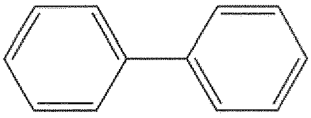 ; 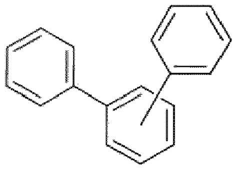 ; 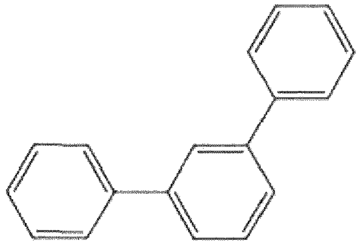

wherein the binding positions for binding to $Ar^1$ and X can be freely selected, preferably a single bond or

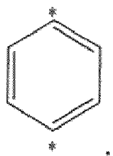 ; 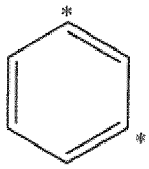 .

If $R^4$ is substituted $C_6$ to $C_{30}$ aryl the one or more substituent(s) may be independently selected from the group consisting of D, $C_1$ to $C_6$ alkyl, $C_1$ to $C_6$ alkoxy, partially or perfluorinated $C_1$ to $C_6$ alkyl, partially or perfluorinated $C_1$ to $C_6$ alkoxy, partially or perdeuterated $C_1$ to $C_6$ alkyl, partially or perdeuterated $C_1$ to $C_6$ alkoxy; $C_6$ to $C_{12}$ aryl, $C_3$ to $C_{11}$ heteroaryl, halogen, CN or $PY(R^{10})_2$, wherein Y is selected from O, S or Se, and $R^{10}$ is independently selected from $C_6$ to $C_{12}$ aryl, $C_3$ to $C_{12}$ heteroaryl, $C_1$ to $C_6$ alkyl, $C_1$ to $C_6$ alkoxy, partially or perfluorinated $C_1$ to $C_6$ alkyl, partially or perfluorinated $C_1$ to $C_6$ alkoxy, partially or perdeuterated $C_1$ to $C_6$ alkyl, partially or perdeuterated $C_1$ to $C_6$ alkoxy,

- wherein each $C_6$ to $C_{12}$ aryl substituent on $Ar^1$ and each $C_3$ to $C_{11}$ heteroaryl substituent on $Ar^1$ may be substituted with one or more selected from $C_1$ to $C_4$ alkyl or halogen.

In case that $R^4$ is substituted, each substituent on $R^4$ may be independently selected from the group consisting of phenyl and $C_1$ to $C_4$ alkyl.

The heterocyclic compound nCG may have the following formula (IV)

$$CG_1\text{-}R^4\text{-}CG^2 \qquad (IV)$$

wherein

$CG^1$ and $CG^2$ are independently selected from groups comprising at least one five-membered ring comprising at least one N-atom and/or at least one six-membered ring comprising at least one N-atom; and

$R_3$ is independently selected from a single bond or substituted or unsubstituted $C_6$ to $C_{30}$ aryl.

$CG^1$ and $CG^2$ may be independently selected from substituted or unsubstituted $C_3$ to $C_{60}$ heteroaryl comprising at least one five-membered ring comprising at least one N-atom and/or at least one six-membered ring comprising at least one N-atom. $CG^1$ and $CG^2$ may be independently selected from substituted or unsubstituted $C_3$ to $C_{54}$ heteroaryl comprising at least one five-membered ring comprising at least one N-atom and/or at least one six-membered ring comprising at least one N-atom. $CG^1$ and $CG^2$ may be independently selected from substituted or unsubstituted $C_3$ to $C_{48}$ heteroaryl comprising at least one five-membered ring comprising at least one N-atom and/or at least one six-membered ring comprising at least one N-atom. $CG^1$ and $CG^2$ may be independently selected from substituted or unsubstituted $C_3$ to $C_{42}$ heteroaryl comprising at least one five-membered ring comprising at least one N-atom and/or at least one six-membered ring comprising at least one N-atom. $CG^1$ and $CG^2$ may be independently selected from substituted or unsubstituted $C_3$ to $C_{36}$ heteroaryl comprising at least one five-membered ring comprising at least one N-atom and/or at least one six-membered ring comprising at least one N-atom. $CG^1$ and $CG^2$ may be independently selected from substituted or unsubstituted $C_3$ to $C_{30}$ heteroaryl comprising at least one five-membered ring

comprising at least one N-atom and/or at least one six-membered ring comprising at least one N-atom. $CG^1$ and $CG^2$ may be independently selected from substituted or unsubstituted $C_3$ to $C_{24}$ heteroaryl comprising at least one five-membered ring comprising at least one N-atom and/or at least one six-membered ring comprising at least one N-atom. $CG^1$ and $CG^2$ may be independently selected from substituted or unsubstituted $C_5$ to $C_{21}$ heteroaryl comprising at least one five-membered ring comprising at least one N-atom and/or at least one six-membered ring comprising at least one N-atom. $CG^1$ and $CG^2$ may be independently selected from substituted or unsubstituted $C_{10}$ to $C_{12}$ heteroaryl comprising at least one five-membered ring comprising at least one N-atom and/or at least one six-membered ring comprising at least one N-atom.

$CG^1$ and $CG^2$ may be independently selected from substituted or unsubstituted

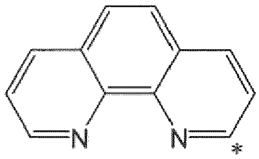 ; 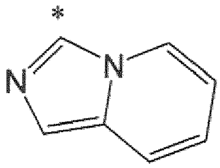 ; 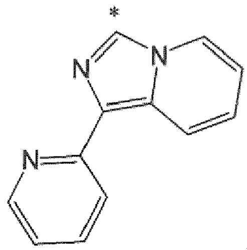 ; 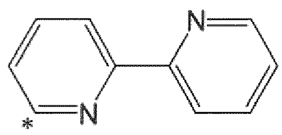 ;

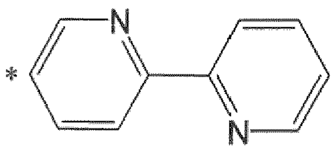 ; 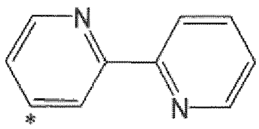 ; 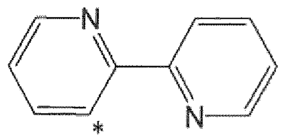 ;

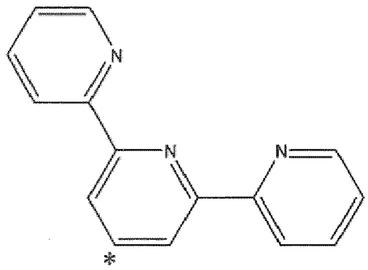

wherein * represents the the binding position to $R^4$.

$CG^1$ and $CG^2$ (including all substituents) may be independently selected from

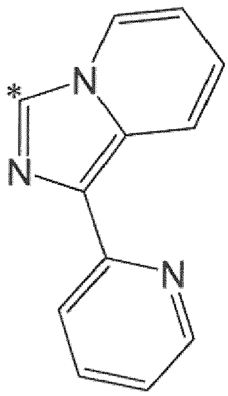 ; 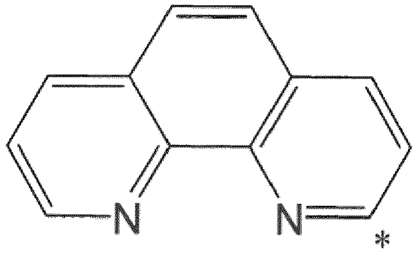 ; 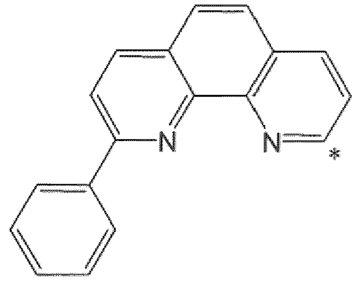

wherein * indicates the binding position to $R^4$.

$R^4$ is independently selected from a single bond or substituted or unsubstituted $C_6$ to $C_{30}$ aryl, alternatively a single

bond or $C_6$ to $C_{24}$ aryl, alternatively a single bond or $C_6$ to $C_{18}$ aryl.

$R^4$ may be selected independently from the group consisting of a single bond, phenylene, naphthylene, biphenylene and terphenylene which may be substituted or unsubstituted, respectively.

$R^4$ may be a single bond or selected independently from one of the following groups or combinations thereof

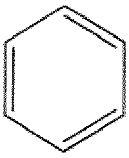 ; 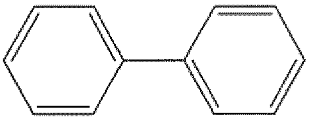 ; 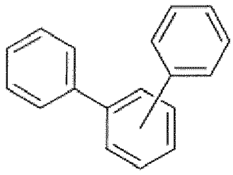 ; 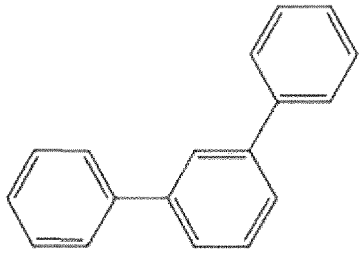

wherein the binding positions for binding to $Ar^1$ and X can be freely selected, preferably a single bond or

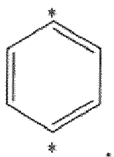 ; 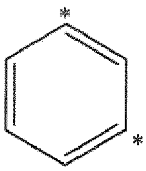 .

If $R^4$ is substituted $C_6$ to $C_{30}$ aryl the one or more substituent(s) may be independently selected from the group consisting of D, $C_1$ to $C_6$ alkyl, $C_1$ to $C_6$ alkoxy, partially or perfluorinated $C_1$ to $C_6$ alkyl, partially or perfluorinated $C_1$ to $C_6$ alkoxy, partially or perdeuterated $C_1$ to $C_6$ alkyl, partially or perdeuterated $C_1$ to $C_6$ alkoxy; $C_6$ to $C_{12}$ aryl, $C_3$ to $C_{11}$ heteroaryl, halogen, CN or $PY(R^{10})_2$, wherein Y is selected from O, S or Se, and $R^{10}$ is independently selected from $C_6$ to $C_{12}$ aryl, $C_3$ to $C_{12}$ heteroaryl, $C_1$ to $C_6$ alkyl, $C_1$ to $C_6$ alkoxy, partially or perfluorinated $C_1$ to $C_6$ alkyl, partially or perfluorinated $C_1$ to $C_6$ alkoxy, partially or perdeuterated $C_1$ to $C_6$ alkyl, partially or perdeuterated $C_1$ to $C_6$ alkoxy,

- wherein each $C_6$ to $C_{12}$ aryl substituent on $Ar^1$ and each $C_3$ to $C_{11}$ heteroaryl substituent on $Ar^1$ may be substituted with one or more selected from $C_1$ to $C_4$ alkyl or halogen.

In case that $R^4$ is substituted, each substituent on $R^4$ may be independently selected from the group consisting of phenyl and $C_1$ to $C_4$ alkyl.

The heterocyclic compound nCG may be selected from nCG-1 to nCG-3

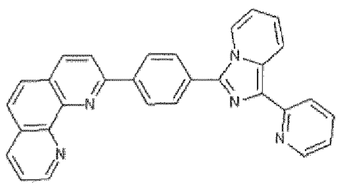
nCG-1

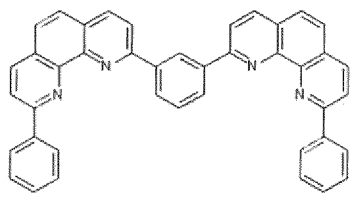
nCG-2

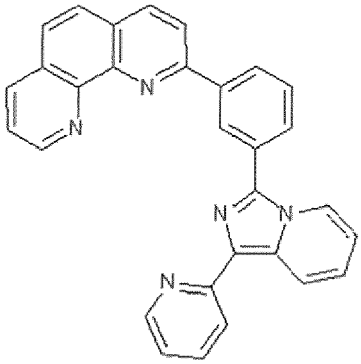

nCG-3.

Organic light emitting diode

The organic light emitting diode according to the present invention comprises an anode, a cathode, a first emission layer, a second emission layer, an n-type charge generation layer, and an electron transport layer.
The n-type charge generation layer is arranged between the first emission layer and the second emission layer.
The electron transport layer is arranged between the first emission layer and the second emission layer
The electron transport layer may be arranged between the first emission layer and the n-type charge generation layer. The electron transport layer may adjacent and in direct contact with the n-type charge generation layer.

*n-type charge generation layer*

The n-type charge generation layer comprises a heterocyclic compound nCG. The n-type charge generation layer may comprise the heterocyclic compound nCG in accordance with the invention in an amount of at least 30 wt.-% with respect to the total weight of the n-type charge generation layer. The n-type charge generation layer may comprise the heterocyclic compound nCG in accordance with the invention in an amount of at least 40 wt.-% with respect to the total weight of the n-type charge generation layer. The n-type charge generation layer may comprise the heterocyclic compound nCG in accordance with the invention in an amount of at least 50 wt.-% with respect to the total weight of the n-type charge generation layer. The n-type charge generation layer may comprise the heterocyclic compound nCG in accordance with the invention in an amount of at least 60 wt.-% with respect to the total weight of the n-type charge generation layer. The n-type charge generation layer may comprise the heterocyclic compound nCG in accordance with the invention in an amount of at least 70 wt.-% with respect to the total weight of the n-type charge generation layer.
The n-type charge generation layer may consist of the heterocyclic compound nCG and the electrical dopant.
The n-type charge generation layer may not comprise the compound of formula (I) and/or the compound of formula (III)
The compound of formula (I), the compound of formula (III) and the heterocyclic compound nCG may be structurally different from each other.
The n-type charge generation layer may have a thickness from 1 to 20 nm, from 5 to 10 nm, or from 7 to 8 nm.

*Electron transport layer*

The electron transport layer comprises a compound of Formula (I). The electron transport layer may comprise the compound of formula (I) in accordance with the invention in an amount of at least 30 wt.-% with respect to the total weight of the electron transport layer. The electron transport layer may comprise the compound of formula (I)in accordance with the invention in an amount of at least 40 wt.-% with respect to the total weight of the electron transport layer. The electron transport layer may comprise the compound of formula (I) in accordance with the invention in an amount of at least 50 wt.-% with respect to the total weight of the electron transport layer. The electron transport layer may comprise the compound of formula (I) in accordance with the invention in an amount of at least 60 wt.-% with respect to the total weight of the electron transport layer. The electron transport layer may comprise the compound of formula (I) in accordance with the invention in an amount of at least 70 wt.-% with respect to the total weight of the electron transport layer. The electron transport layer may comprise the compound of formula (I) in accordance with the invention in an amount of at least 8o wt.-% with respect to the total weight of the electron transport layer. The electron transport layer may comprise the compound of formula (I) in accordance with the invention in an amount of at least 90 wt.-% with respect to the total weight of the electron transport layer. The electron transport layer may comprise the compound of formula (I) in accordance with the invention in an amount of at least 95 wt.-% with respect to the total weight of the electron transport layer. The electron transport layer may comprise

the compound of formula (I) in accordance with the invention in an amount of at least 98 wt.-% with respect to the total weight of the electron transport layer. The electron transport layer may comprise the compound of formula (I) in accordance with the invention in an amount of at least 99 wt.-% with respect to the total weight of the electron transport layer.

The electron transport layer may consist of the compound of formula (I).

The electron transport layer may have a thickness from 10 to 50 nm, from 10 to 40 nm, from 10 to 30 nm, from 10 to 20 nm, or from 10 to 15 nm.

It may be provided that the compound of formula (I) does not have the structure aET-1

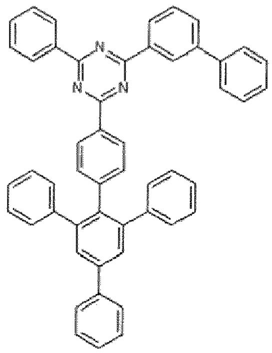

aET-1

and that the electron transport layer does not comprise the compound of formula aET-1.

It may be provided that a device comprising aET-1 in the ETL and at the same time nCG-1 in the n-type charge generation layer is excluded.

It may be provided that a device having an ETL consisting of aET-1 and at the same time comprising nCG-1 in the n-type charge generation layer is excluded.

It may be provided that a device having an ETL consisting of aET-1 and at the same time having an n-type charge generation layer consisting of nCG-1 and Yb is excluded.

It may be provided that a device having an ETL consisting of aET-1 and at the same time having an n-type charge generation layer consisting of nCG-1 and 9.9 wt.-% Yb is excluded.

*Electrical dopant*

The electron transport layer is free from an electrical dopant. The n-type charge generation layer may comprise an electrical dopant.

Under electrical dopant, especially n-type dopant it is understood a compound which, if embedded into an electron transport matrix, improves, in comparison with the neat matrix under the same physical conditions, the electron properties of the formed organic material, particularly in terms of electron injection and/or electron conductivity.

In the context of the present invention "embedded into an electron transport matrix" means homogenously mixed with the electron transport matrix.

The electrical dopant as referred to herein is especially selected from elemental metals, metal salts, metal complexes and organic radicals.

In one embodiment, the electrical dopant is selected from alkali metal salts and alkali metal complexes; preferably from lithium salts and lithium organic complexes; more preferably from lithium halides and lithium organic chelates; even more preferably from lithium fluoride, a lithium quinolinolate, lithium borate, lithium phenolate, lithium pyridinolate or from a lithium complex with a Schiff base ligand; most preferably,

- the lithium complex has the formula II, III or IV:

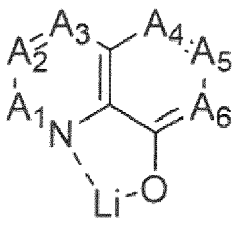 (II), 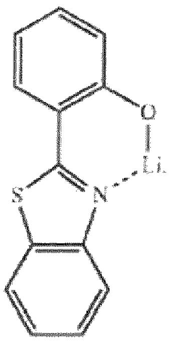 (III), 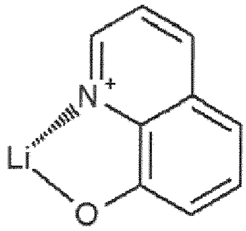 (IV)

wherein

$A_1$ to $A_6$ are same or independently selected from CH, CR, N, O;

R is same or independently selected from hydrogen, halogen, alkyl or aryl or heteroaryl with 1 to 20 carbon atoms; and more preferred $A_1$ to $A_6$ are CH,

- the borate based organic ligand is a tetra(1H-pyrazol-1-yl)borate,
- the phenolate is a 2-(pyridin-2-yl)phenolate, a 2-(diphenylphosphoryl)phenolate, an imidazol phenolate, 2-(pyridin-2-yl)phenolate or 2-(1-phenyl-1H-benzo[d]imidazol-2-yl)phenolate,
- the pyridinolate is a 2-(diphenylphosphoryl)pyridin-3-olate,
- the lithium Schiff base has the structure 100, 101, 102 or 103:

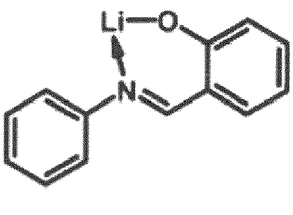 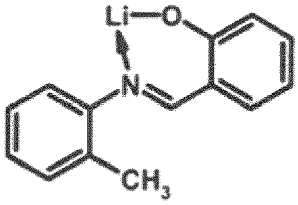 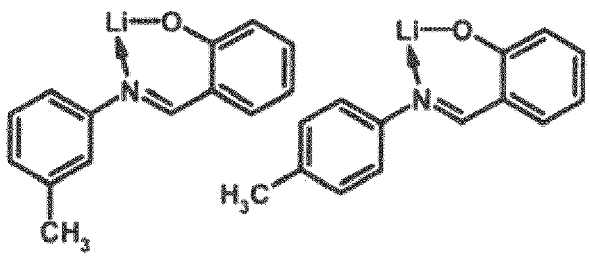

100 101 102 103

According to one embodiment of the invention, the electron transport layer of the present invention comprises a lithium organic complex, especially may comprise 8-hydroxyquinolinolato-lithium (= LiQ).

According to one embodiment of the present invention the electron transport layer comprsises a metal, preferably selected from alkali metals, alkaline earth metals, rare earth metals and metals of the transition period Ti, V, Cr and Mn, especially selected from Li, Na, K, Rb, Cs, Mg, Ca, Sr, Ba, Sm, Eu, Tm, Yb; more preferably from Li, Na, K, Rb, Cs, Mg and Yb, even more preferably from Li, Na, Cs and Yb, most preferably from Li, Na and Yb.

The most practical benchmark for the strength of an n-dopant is the value of its redox potential. There is no particular limitation in terms how negative the value of the redox potential can be.

As reduction potentials of usual electron transport matrices used in organic semiconductors are, if measured by cyclic voltammetry against ferrocene/ferrocenium reference redox couple, roughly in the range from about - 0.8 V to about - 3.1V; the practically applicable range of redox potentials for n-type dopants which can effectively n-dope such matrices is in a slightly broader range, from about - 0.5 to about - 3.3 V.

The measurement of redox potentials is practically performed for a corresponding redox couple consisting of the reduced and of the oxidized form of the same compound.

In case that the n-type dopant is an electrically neutral metal complex and/or an electrically neutral organic radical, the measurement of its redox potential is actually performed for the redox couple formed by

(i) the electrically neutral metal complex and its cation radical formed by an abstraction of one electron from the electrically neutral metal complex, or

(ii) the electrically neutral organic radical and its cation formed by an abstraction of one electron from the electrically neutral organic radical.

Preferably, the redox potential of the electrically neutral metal complex and/or of the electrically neutral organic radical may have a value which is more negative than - 0.5 V, preferably more negative than - 1.2 V, more preferably more negative than - 1.7 V, even more preferably more negative than - 2.1 V, most preferably more negative than - 2.5 V, if measured by cyclic voltammetry against ferrocene/ferrocenium reference redox couple for a corresponding redox couple consisting of

(i) the electrically neutral metal complex and its cation radical formed by an abstraction of one electron from the electrically neutral metal complex, or

(ii) the electrically neutral organic radical and its cation formed by an abstraction of one electron from the electrically neutral organic radical.

In a preferred embodiment, the redox potential of the n-dopant is between the value which is about 0.5 V more positive and the value which is about 0.5 V more negative than the value of the reduction potential of the chosen electron transport matrix.

Electrically neutral metal complexes suitable as n-type dopants may be e.g. strongly reductive complexes of some transition metals in low oxidation state. Particularly strong n-type dopants may be selected for example from Cr(II), Mo(II) and/or W(II) guanidinate complexes such as $W_2(hpp)_4$, as described in more detail in WO2005/086251.

Electrically neutral organic radicals suitable as n-type dopants may be e.g. organic radicals created by supply of additional energy from their stable dimers, oligomers or polymers, as described in more detail in EP 1 837 926 B1, WO2007/107306, or WO2007/107356. Under an elemental metal, it is understood a metal in a state of a neat metal, of a metal alloy, or in a state of free atoms or metal clusters. It is understood that metals deposited by vacuum thermal evaporation from a metallic phase, e.g. from a neat bulk metal, vaporize in their elemental form. It is further understood that if the vaporized elemental metal is deposited together with a covalent matrix, the metal atoms and/or clusters are embedded in the covalent matrix. In other words, it is understood that any metal-doped covalent material prepared by vacuum thermal evaporation contains the metal at least partially in its elemental form.

For the use in consumer electronics, only metals containing stable nuclides or nuclides having very long halftime of radioactive decay might be applicable. As an acceptable level of nuclear stability, the nuclear stability of natural potassium can be taken.

In one embodiment, the electrical may be selected from electropositive metals selected from alkali metals, alkaline earth metals, rare earth metals and metals of the first transition period Ti, V, Cr and Mn. Preferably, the n-dopant may be selected from Li, Na, K, Rb, Cs, Mg, Ca, Sr, Ba, Sm, Eu, Tm, Yb; more preferably from Li, Na, K, Rb, Cs, Mg and Yb, even more preferably from Li, Na, Cs and Yb, most preferably from Li, Na and Yb.

*Auxiliary electron transport layer*

The organic light emitting diode may further comprise an auxiliary electron transport layer, wherein the auxiliary electron transport layer is arranged between the first emission layer and the electron transport layer.

If present, the auxiliary electron transport layer may comprise the compound of formula (III) according to the present disclosure. The auxiliary electron transport layer may comprise the compound of formula (III) in an amount of 30 w.-% or more with respect to the total weight of the auxiliary electron transport layer, of 40 w.-% or more with respect to the total weight of the auxiliary electron transport layer, of 50 w.-% or more with respect to the total weight of the auxiliary electron transport layer, of 6o w.-% or more with respect to the total weight of the auxiliary electron transport layer, of 70 w.-% or more with respect to the total weight of the auxiliary electron transport layer, of 80 w.-% or more with respect to the total weight of the auxiliary electron transport layer, of 90 w.-% or more with respect to the total weight of the auxiliary electron transport layer, of 95 w.-% or more with respect to the total weight of the auxiliary electron transport layer, of 98 w.-% or more with respect to the total weight of the auxiliary electron transport layer, or of 99 w.-% or more with respect to the total weight of the auxiliary electron transport layer, or may consist of a compound (III).

The auxiliary electron transport layer may also be referred to as a second electron transport layer or as a hole blocking layer.

The auxiliary electron transport layer may be in direct contact with the electron transport layer. The auxiliary electron transport layer may be in direct contact with the first emission layer. The auxiliary electron transport layer may be contacting sandwiched between the first emission layer and the electron transport layer.

The electron transport layer may be contacting sandwiched between the auxiliary electron transport layer and the n-type charge generation layer.

The auxiliary electron transport layer may have a thickness of < 50 nm, optionally between 1 and 30 nm, optionally between 1 and 10 nm, optionally between 1 and 5 nm.

*Specific embodiments*

In one embodiment, the invention relates to an organic light emitting diode comprising an anode, a cathode, a first emission layer, a second emission layer, an n-type charge generation layer, and an electron transport layer, wherein

- the n-type charge generation layer is arranged between the first emission layer and the second emission layer;
- electron transport layer is arranged between the first emission layer and the second emission layer;
- the n-type charge generation layer comprises a heterocyclic compound nCG, wherein the heterocyclic compound nCG comprises at least two moieties selected from the group consisting of bipyridine, terpyridine, phenanthroline, pyridine-imidazo-pyridine, pyridine-benzimidazole;
- the electron transport layer comprises a compound of Formula (I)

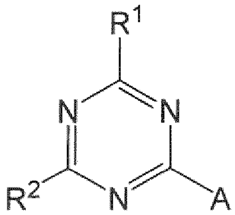 (I)

- $R^1$ is selected from

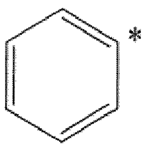 ; 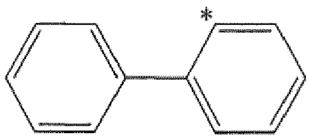 ; and 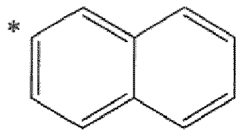

wherein * represents the binding position of $R^1$ to

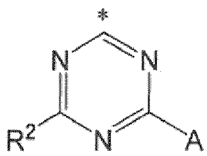 ;

- A is selected from the group consisting of unsubstituted or substituted naphthyl, unsubstituted or substituted biphenyl, and unsubstituted or substituted dibenzofuranyl,
  - wherein if A is substituted, the one or more substituent(s) are independently selected from the group consisting of D and $C_1$ to $C_6$ alkyl;
- $R^2$ is a group of Formula (II)

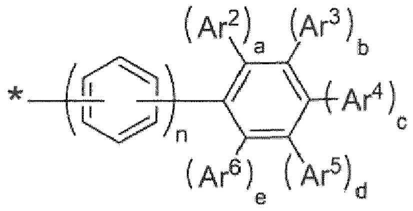

(II)

- * represents the binding position to the remaining structure of Formula (I);
- a, b, c, d, e are independently o or 1, wherein $2 \leq a+b+c+d+e \leq 4$;
- "n" is 1 or 2;
- $Ar^2$, $Ar^3$, $Ar^4$, $Ar^5$, and $Ar^6$ are independently selected from the group consisting of substituted or unsubstituted phenyl,
    - wherein if one or more of $Ar^2$, $Ar^3$, $Ar^4$, $Ar^5$, and $Ar^6$ is substituted, the one or more substituent(s) are independently selected from the group consisting of D and $C_1$ to $C_6$ alkyl;
- the dipole moment of the compound of Formula (1) is ≥ 0 D and ≤ 1 D;
- A is chosen so that the dipole moment of a compound "A-phenyl" is ≥ 0 D and ≤ 1 D; and
- the electron transport layer is free from an electrical dopant.

In one embodiment, the invention relates to an organic light emitting diode comprising an anode, a cathode, a first emission layer, a second emission layer, an n-type charge generation layer, an electron transport layer, and an auxiliary electron transport layer;
wherein

- the n-type charge generation layer is arranged between the first emission layer and the second emission layer;
- electron transport layer is arranged between the first emission layer and the second emission layer;
- the auxiliary electron transport layer is arranged between the first emission layer and the second emission layer;
- the n-type charge generation layer comprises a heterocyclic compound nCG, wherein the heterocyclic compound nCG comprises at least two moieties selected from the group consisting of bipyridine, terpyridine, phenanthroline, pyridine-imidazo-pyridine, pyridine-benzimidazole;
- the auxiliary electron transport layer comprises a compound aET, wherein the LUMO energy level of the compound aET in the absolute scale taking vacuum energy level as zero, computed by the TURBOMOLE V6.5 program package using hybrid functional B3LYP and Gaussian 6-31G* basis set, is in the range from -1.90 eV to -1.50 eV;
- the electron transport layer comprises a compound of Formula (I)

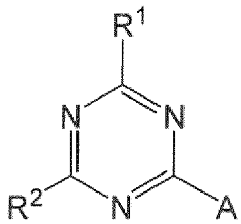

(I)

- $R^1$ is selected from

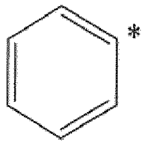
;
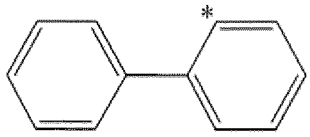
; and
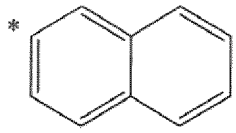

wherein * represents the binding position of $R^1$ to

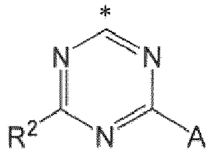
;

- A is selected from the group consisting of unsubstituted or substituted naphthyl, unsubstituted or substituted biphenyl, and unsubstituted or substituted dibenzofuranyl,
  - wherein if A is substituted, the one or more substituent(s) are independently selected from the group consisting of D and $C_1$ to $C_6$ alkyl;
- $R^2$ is a group of Formula (II)

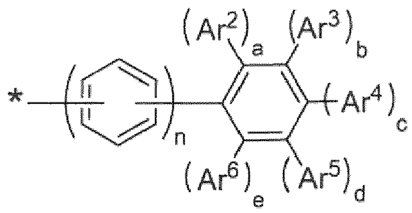
(II)

- * represents the binding position to the remaining structure of Formula (I);
- a, b, c, d, e are independently 0 or 1, wherein $2 \leq a+b+c+d+e \leq 4$;
- "n" is 1 or 2;
- $Ar^2$, $Ar^3$, $Ar^4$, $Ar^5$, and $Ar^6$ are independently selected from the group consisting of substituted or unsubstituted phenyl,
  - wherein if one or more of $Ar^2$, $Ar^3$, $Ar^4$, $Ar^5$, and $Ar^6$ is substituted, the one or more substituent(s) are independently selected from the group consisting of D and $C_1$ to $C_6$ alkyl;
- the dipole moment of the compound of Formula (1) is ≥ 0 D and ≤ 1 D;
- A is chosen so that the dipole moment of a compound "A-phenyl" is ≥ 0 D and ≤ 1 D; and
- the electron transport layer is free from an electrical dopant.

*Further layers*

In accordance with the invention, the organic light emitting diode may comprise, besides the layers already mentioned above, further layers. Exemplary embodiments of respective layers are described in the following:

*Substrate*

The substrate may be any substrate that is commonly used in manufacturing of, electronic devices, such as organic light-emitting diodes. If light is to be emitted through the substrate, the substrate shall be a transparent or semitransparent material, for example a glass substrate or a transparent plastic substrate. If light is to be emitted through

the top surface, the substrate may be both a transparent as well as a non-transparent material, for example a glass substrate, a plastic substrate, a metal substrate or a silicon substrate. It may be provided that the substrate is a non-transparent substrate.

*Anode electrode*

The organic light emitting diode comprises an anode electrode ("anode"). The anode electrode may be formed by depositing or sputtering a material that is used to form the anode electrode. The material used to form the anode electrode may be a high work-function material, so as to facilitate hole injection. The anode material may also be selected from a low work function material (i.e. aluminum). The anode electrode may be a transparent or reflective electrode. Transparent conductive oxides, such as indium tin oxide (ITO), indium zinc oxide (IZO), tin-dioxide ($SnO_2$), aluminum zinc oxide (AlZO) and zinc oxide (ZnO), may be used to form the anode electrode. The anode electrode may also be formed using metals, typically silver (Ag), gold (Au), or metal alloys.

*Hole injection layer*

A hole injection layer (HIL) may be formed on the anode electrode by vacuum deposition, spin coating, printing, casting, slot-die coating, Langmuir-Blodgett (LB) deposition, or the like. When the HIL is formed using vacuum deposition, the deposition conditions may vary according to the compound that is used to form the HIL, and the desired structure and thermal properties of the HIL. In general, however, conditions for vacuum deposition may include a deposition temperature of 100° C to 500° C, a pressure of 10-8 to 10-3 Torr (1 Torr equals 133.322 Pa), and a deposition rate of 0.1 to 10 nm/sec.

When the HIL is formed using spin coating or printing, coating conditions may vary according to the compound that is used to form the HIL, and the desired structure and thermal properties of the HIL. For example, the coating conditions may include a coating speed of about 2000 rpm to about 5000 rpm, and a thermal treatment temperature of about 80° C to about 200° C. Thermal treatment removes a solvent after the coating is performed.

The HIL may be formed of any compound that is commonly used to form a HIL. Examples of compounds that may be used to form the HIL include a phthalocyanine compound, such as copper phthalocyanine (CuPc), 4,4',4"-tris (3-methylphenylphenylamino) triphenylamine (m-MTDATA), TDATA, 2T-NATA, polyaniline/dodecylbenzenesulfonic acid (Pani/DBSA), poly(3,4-ethylenedioxythiophene)/poly(4-styrenesulfonate) (PEDOT/PSS), polyaniline/camphor sulfonic acid (Pani/CSA), and polyaniline)/poly(4-styrenesulfonate (PANI/PSS).

The HIL may comprise or consist of p-type dopant and the p-type dopant may be selected from tetrafluoro-tetracyanoquinonedimethane ($F_4TCNQ$), 2,2'-(perfluoronaphthalen-2,6-diylidene) dimalononitrile or 2,2',2"-(cyclopropane-1,2,3-triylidene)tris(2-(p-cyanotetrafluorophenyl)acetonitrile) but not limited hereto. The HIL may be selected from a hole-transporting matrix compound doped with a p-type dopant. Typical examples of known doped hole transport materials are: copper phthalocyanine (CuPc), which HOMO level is approximately -5.2 eV, doped with tetrafluoro-tetracyanoquinonedimethane ($F_4TCNQ$), which LUMO level is about -5.2 eV; zinc phthalocyanine (ZnPc) (HOMO = -5.2 eV) doped with $F_4TCNQ$; $\alpha$-NPD (N,N'-Bis(naphthalen-1-yl)-N,N'-bis(phenyl)-benzidine) doped with $F_4TCNQ$. $\alpha$-NPD doped with 2,2'-(perfluoronaphthalen-2,6-diylidene) dimalononitrile. The p-type dopant concentrations can be selected from 1 to 20 wt.-%, more preferably from 3 wt.-% to 10 wt.-%.

The thickness of the HIL may be in the range from about 1 nm to about 100 nm, and for example, from about 1 nm to about 25 nm. When the thickness of the HIL is within this range, the HIL may have excellent hole injecting characteristics, without a substantial penalty in driving voltage.

*Hole transport layer*

A hole transport layer (HTL) may be formed on the HIL by vacuum deposition, spin coating, slot-die coating, printing, casting, Langmuir-Blodgett (LB) deposition, or the like. When the HTL is formed by vacuum deposition or spin coating, the conditions for deposition and coating may be similar to those for the formation of the HIL. However, the conditions for the vacuum or solution deposition may vary, according to the compound that is used to form the HTL.

The HTL may be formed of any compound that is commonly used to form a HTL. Compounds that can be suitably used are disclosed for example in Yasuhiko Shirota and Hiroshi Kageyama, Chem. Rev. 2007, 107, 953-1010 and incorporated by reference. Examples of the compound that may be used to form the HTL are: carbazole derivatives, such as N-phenylcarbazole or polyvinylcarbazole; benzidine derivatives, such as N,N'-bis(3-methylphenyl)-N,N'-diphenyl-[1,1-biphenyl]-4,4'-diamine (TPD), or N,N'-di(naphthalen-1-yl)-N,N'-diphenyl benzidine (alpha-NPD); and triphenylamine-based compound, such as 4,4',4"-tris(N-carbazolyl)triphenylamine (TCTA). Among these compounds, TCTA can transport holes and inhibit excitons from being diffused into the EML.

The thickness of the HTL may be in the range of about 5 nm to about 250 nm, preferably, about 10 nm to about 200 nm, further about 20 nm to about 190 nm, further about 40 nm to about 180 nm, further about 60 nm to about 170 nm, further

about 80 nm to about 160 nm, further about 100 nm to about 160 nm, further about 120 nm to about 140 nm. A preferred thickness of the HTL may be 170 nm to 200 nm.

When the thickness of the HTL is within this range, the HTL may have excellent hole transporting characteristics, without a substantial penalty in driving voltage.

*Electron blocking layer*

The function of an electron blocking layer (EBL) is to prevent electrons from being transferred from an emission layer to the hole transport layer and thereby confine electrons to the emission layer. Thereby, efficiency, operating voltage and/or lifetime are improved. Typically, the electron blocking layer comprises a triarylamine compound. The triarylamine compound may have a LUMO level closer to vacuum level than the LUMO level of the hole transport layer. The electron blocking layer may have a HOMO level that is further away from vacuum level compared to the HOMO level of the hole transport layer. The thickness of the electron blocking layer may be selected between 2 and 20 nm.

If the electron blocking layer has a high triplet level, it may also be described as triplet control layer.

The function of the triplet control layer is to reduce quenching of triplets if a phosphorescent green or blue emission layer is used. Thereby, higher efficiency of light emission from a phosphorescent emission layer can be achieved. The triplet control layer is selected from triarylamine compounds with a triplet level above the triplet level of the phosphorescent emitter in the adjacent emission layer. Suitable compounds for the triplet control layer, in particular the triarylamine compounds, are described in EP 2 722 908 A1.

*Emission layer (EML)*

The first emission layer and the second emission layer in the organic light emitting diode in accordance with the invention may be a blue emission layer or a green emission layer, respectively.

The EML may be formed on the HTL by vacuum deposition, spin coating, slot-die coating, printing, casting, LB deposition, or the like. When the EML is formed using vacuum deposition or spin coating, the conditions for deposition and coating may be similar to those for the formation of the HIL. However, the conditions for deposition and coating may vary, according to the compound that is used to form the EML.

It may be provided that the emission layer does not comprise the compound of Formula (I) and/or the compound of Formula (III) and/or the heterocyclic compound nCG.

The emission layer (EML) may be formed of a combination of a host and an emitter dopant. Example of the host are Alq3, 4,4'-N,N'-dicarbazole-biphenyl (CBP), poly(n-vinylcarbazole) (PVK), 9,10-di(naphthalene-2-yl)anthracene (ADN), 4,4',4"-tris(carbazol-9-yl)-triphenylamine(TCTA), 1,3,5-tris(N-phenylbenzimidazole-2-yl)benzene (TPBI), 3-tert-butyl-9,10-di-2-naphthylanthracenee (TBADN), distyrylarylene (DSA) and bis(2-(2-hydroxyphenyl)benzo-thiazolate)zinc ($Zn(BTZ)_2$).

The emitter dopant may be a phosphorescent or fluorescent emitter. Phosphorescent emitters and emitters which emit light via a thermally activated delayed fluorescence (TADF) mechanism may be preferred due to their higher efficiency. The emitter may be a small molecule or a polymer.

Examples of red emitter dopants are PtOEP, $Ir(piq)_3$, and $Btp_2Ir(acac)$, but are not limited thereto. These compounds are phosphorescent emitters, however, fluorescent red emitter dopants could also be used.

Examples of phosphorescent green emitter dopants are $Ir(ppy)_3$ (ppy = phenylpyridine), $Ir(ppy)_2(acac)$, $Ir(m\text{-}pyp)_3$.

Examples of phosphorescent blue emitter dopants are $F_2Irpic$, $(F_2ppy)_2Ir(tmd)$ and $Ir(dfppz)_3$ and ter-fluorene. 4.4'-bis(4-diphenyl amiostyryl)biphenyl (DPAVBi), 2,5,8,11-tetra-tert-butyl perylene (TBPe) are examples of fluorescent blue emitter dopants.

The amount of the emitter dopant may be in the range from about 0.01 to about 50 parts by weight, based on 100 parts by weight of the host. Alternatively, the emission layer may consist of a light-emitting polymer. The EML may have a thickness of about 10 nm to about 100 nm, for example, from about 20 nm to about 60 nm. When the thickness of the EML is within this range, the EML may have excellent light emission, without a substantial penalty in driving voltage.

*Hole blocking layer (HBL)*

The OLED according to the present invention may comprise an auxiliary electron transport layer, also called hole blocking layer (HBL).

Especially if the organic light emitting device is a tandem OLED or another device comprising multiple layer stacks, the organic light emitting device may comprise more than one auxiliary electron transport layer ("hole blocking layer"), that is, one or more additional auxiliary electron transport layer(s).

The HBL(s) may be the auxiliary electron transport layer as defined above. Alternatively, for additional HBls, any

compound that is commonly used to form a HBL may be used. Examples of compounds for forming the HBL include oxadiazole derivatives, triazole derivatives, and phenanthroline derivatives.

The HBL may be formed on the EML, by using vacuum deposition, spin coating, slot-die coating, printing, casting, LB deposition, or the like, in order to prevent the diffusion of holes into the ETL. When the EML comprises a phosphorescent dopant, the HBL may have also a triplet exciton blocking function.

The HBL may have a thickness in the range from about 5 nm to about 100 nm, for example, from about 5 nm to about 30 nm. When the thickness of the HBL is within this range, the HBL may have excellent hole-blocking properties, without a substantial penalty in driving voltage.

In a preferred embodiment the HBL does not comprise a compound of formula (I) and/or the heterocyclic compound nCG.

*Electron transport layer (ETL)*

The OLED according to the present invention comprises an electron transport layer (ETL). Especially since the organic light emitting device is a tandem OLED, the organic light emitting device may comprise more than one electron transport layer, that is, one or more additional electron transport layer(s) ("additional ETL").

By suitably adjusting energy levels of particular layers of the additional ETL, the injection and transport of the electrons may be controlled, and the holes may be efficiently blocked. Thus, the OLED may have long lifetime.

The additional ETL may comprise ETM materials known in the art. Suitable compounds for the ETM are not particularly limited.

In one embodiment, the electron transport matrix compounds consist of covalently bound atoms. Preferably, the electron transport matrix compound comprises a conjugated system of at least 6, more preferably of at least 10 delocalized electrons. In one embodiment, the conjugated system of delocalized electrons may be comprised in aromatic or heteroaromatic structural moieties, as disclosed e.g. in documents EP 1970 371 A1 or WO 2013/079217 A1.

*Electron injection layer (EIL)*

An EIL, which may facilitate injection of electrons from the cathode into the electron transport layer stack, may be formed on the electron transport layer, preferably directly on the electron transport layer. Materials and properties of the EIL are defined above.

It may be provided that the electron injection layer does not comprise the compound of formula (I) and/or the compound of formula (III) and/or the heterocyclic compound nCG.

*Cathode electrode*

The cathode (cathode electrode) is formed on the EIL (if present) or on the ETL, preferably directly on the EIL, preferably in direct contact with the EIL. In the sense of this invention the cathode and the EIL can be regarded as one functional part enabling the injection of electrons into the electron transport layer stack. The cathode electrode may be formed of a metal, an alloy, an electrically conductive compound, or a mixture thereof. The cathode electrode may have a low work function. For example, the cathode electrode may be formed of lithium (Li), magnesium (Mg), aluminum (Al), aluminum (Al)-lithium (Li), calcium (Ca), barium (Ba), ytterbium (Yb), magnesium (Mg)-indium (In), magnesium (Mg)-silver (Ag), or the like, for example an alloy of Ag and Mg, such as Ag:Mg 90:10 wt/wt. Alternatively, the cathode electrode may be formed of a transparent conductive oxide, such as ITO or IZO.

The thickness of the cathode electrode may be in the range from about 5 nm to about 1000 nm, for example, in the range from about 10 nm to about 100 nm. When the thickness of the cathode electrode is in the range from about 5 nm to about 50 nm, the cathode electrode may be transparent or semitransparent even if formed from a metal or metal alloy. The transparent or semitransparent cathode may facilitate light emission through the cathode.

*Charge generation layer (CGL)*

The charge generation layer (CGL) may comprise a p-type charge generation layer (p-CGL) and the n-type charge generation layer (n-CGL). An interlayer maybe arranged between the p-CGL and the -n-CGL.

Typically, the charge generation layer is a p-n junction joining an n-type charge generation layer (electron generating layer) and a hole generating layer. The n-side of the p-n junction generates electrons and injects them into the layer that is adjacent in the direction to the anode. Analogously, the p-side of the p-n junction generates holes and injects them into the layer that is adjacent in the direction to the cathode.

Charge generating layers are used in tandem and stacked devices, for example, in tandem or stacked OLEDs comprising, between two electrodes, two or more emission layers. In a tandem or stacked OLED comprising two emission

layers, the n-type charge generation layer provides electrons for the first light emission layer arranged near the anode, while the hole generating layer provides holes to the second light emission layer arranged between the first emission layer and the cathode.

Suitable matrix materials for the hole generating layer may be materials conventionally used as hole injection and/or hole transport matrix materials. Also, p-type dopant used for the hole generating layer can employ conventional materials. For example, the p-type dopant can be one selected from a group consisting of tetrafluoro-7,7,8,8-tetracyanoquinodimethane ($F_4$-TCNQ), derivatives of tetracyanoquinodimethane, radialene derivatives, iodine, $FeCl_3$, $FeF_3$, and $SbCl_5$. Also, the host can be one selected from a group consisting of N,N'-di(naphthalen-1-yl)-N,N-diphenyl-benzidine (NPB), N,N'-diphenyl-N,N'-bis(3-methylphenyl)-1,1-biphenyl-4,4'-diamine (TPD) and N,N',N'-tetranaphthyl-benzidine (TNB). The p-type charge generation layer may consist of CNHAT.

The n-type charge generating layer is the layer comprising the heterocyclic compound nCG. The n-type charge generation layer can be layer of a neat n-type dopant, for example of a metal, or can consist of an organic matrix material doped with the n-type dopant. In one embodiment, the n-type dopant can be alkali metal, alkali metal compound, alkaline earth metal, alkaline earth metal compound, a transition metal, a transition metal compound or a rare earth metal. In another embodiment, the metal can be one selected from a group consisting of Li, Na, K, Rb, Cs, Mg, Ca, Sr, Ba, La, Ce, Sm, Eu, Tb, Dy, and Yb. More specifically, the n-type dopant can be one selected from a group consisting of Li, Cs, K, Rb, Mg, Na, Ca, Sr, Eu and Yb.

According to one aspect of the present invention, an electron transport layer comprising the compound of formula (I) is arranged between a first and a second emission layer and a further electron transport layer comprising the compound of formula (I) is arranged between the second emission layer and the cathode.

According to various embodiments of the present invention, there may be provided OLEDs layers arranged between the above mentioned layers, on the substrate or on the top electrode.

In one embodiment, the organic light emitting device according to the invention further comprises a layer comprising a radialene compound and/or a quinodimethane compound.

In one embodiment, the radialene compound and/or the quinodimethane compound may be substituted with one or more halogen atoms and/or with one or more electron withdrawing groups. Electron withdrawing groups can be selected from nitrile groups, halogenated alkyl groups, alternatively from perhalogenated alkyl groups, alternatively from perfluorinated alkyl groups. Other examples of electron withdrawing groups may be acyl, sulfonyl groups or phosphoryl groups.

Alternatively, acyl groups, sulfonyl groups and/or phosphoryl groups may comprise halogenated and/or perhalogenated hydrocarbyl. In one embodiment, the perhalogenated hydrocarbyl may be a perfluorinated hydrocarbyl. Examples of a perfluorinated hydrocarbyl can be perfluormethyl, perfluorethyl, perfluorpropyl, perfluorisopropyl, perfluorobutyl, perfluorophenyl, perfluorotolyl; examples of sulfonyl groups comprising a halogenated hydrocarbyl may be trifluoromethylsulfonyl, pentafluoroethylsulfonyl, pentafluorophenylsulfonyl, heptafluoropropylsufonyl, nonafluorobutylsulfonyl, and like.

In one embodiment, the radialene and/or the quinodimethane compound may be comprised in a hole injection, hole transporting and/or a hole generation layer.

In one embodiment, the radialene compound may have Formula (XX) and/or the quinodimethane compound may have Formula (XXIa) or (XXIb):

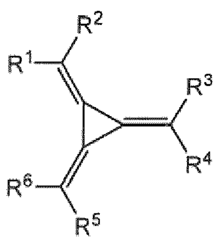
(XX)
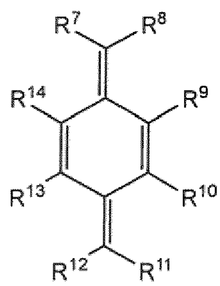
(XXIa)
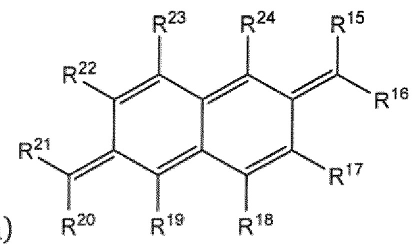
(XXIb),

wherein (as an exception different to the description above) $R^1$, $R^2$, $R^3$, $R^4$, $R^5$, $R^6$, $R^7$, $R^8$, $R^{11}$, $R^{12}$, $R^{15}$, $R^{16}$, $R^{20}$, $R^{21}$ are independently selected from above mentioned electron withdrawing groups and $R^9$, $R^{10}$, $R^{13}$, $R^{14}$, $R^{17}$, $R^{18}$, $R^{19}$, $R^{22}$, $R^{23}$ and $R^{24}$ are independently selected from H, halogen and above mentioned electron withdrawing groups.

Process for preparing the organic light emitting device

According to a further aspect, the invention is related to a process for preparing the organic light emitting device according to the present invention, wherein the process comprises a step of depositing the compound of formula (I) according to the present invention on a solid support.

The method for depositing may comprise:

- deposition via vacuum thermal evaporation;
- deposition via solution processing, preferably the processing is selected from spin-coating, printing, casting; and/or
- slot-die coating.

Device

According to a further aspect, the invention is related to a display device or a lighting device comprising the organic light emitting device according to the invention, preferably comprises at least two organic light emitting devices according to the invention.

The display device may be a television, a tablet, or a mobile phone.

GENERAL DEFINITIONS

If not explicitly mentioned else, each moiety of the compounds described herein, especially the compounds of formula (I), the compound of formula (II) and the heterocyclic compound nCG may be substituted with one or more D (deuterium).

In the present specification, when a definition is not otherwise provided, an "alkyl group" may refer to an aliphatic hydrocarbon group. The alkyl group may refer to "a saturated alkyl group" without any double bond or triple bond. The term "alkyl" as used herein shall encompass linear as well as branched and cyclic alkyl. For example, $C_3$-alkyl may be selected from n-propyl and iso-propyl. Likewise, $C_4$-alkyl encompasses n-butyl, sec-butyl and t-butyl. Likewise, $C_6$-alkyl encompasses n-hexyl and cyclo-hexyl.

As used herein if not explicitly mentioned else, the asterisk symbol "*" represents a binding position at which the moiety labelled accordingly is bond to another moiety.

The term "aryl" or "arylene" as used herein shall encompass phenyl ($C_6$-aryl), fused aromatics, such as naphthalene, anthracene, phenanthrene, tetracene etc.. Further encompassed are biphenyl and oligo- or polyphenyls, such as terphenyl, phenyl-substituted biphenyl, phenyl-substituted terphenyl (such as tetraphenyl benzene groups) etc.. "Arylene" respectively "heteroarylene", refers to groups to which two further moieties are attached. In the present specification, the term "aryl group" or "arylene group" may refer to a group comprising at least one hydrocarbon aromatic moiety, and all the elements of the hydrocarbon aromatic moiety may have p-orbitals which form conjugation, for example a phenyl group, a napthyl group, an anthracenyl group, a phenanthrenyl group, a pyrenyl group, a fluorenyl group and the like. Further encompoassed are spiro compounds in which two aromatic moieties are connected with each other via a spiro-atom, such as 9,9'-spirobi[9H-fluorene]yl. The aryl or arylene group may include a monocyclic or fused ring polycyclic (i.e., links sharing adjacent pairs of carbon atoms) functional group.

The term "heteroaryl" as used herein refers to aryl groups in which at least one carbon atom is substituted with a heteroatom. The term "heteroaryl" may refer to aromatic heterocycles with at least one heteroatom, and all the elements of the hydrocarbon heteroaromatic moiety may have p-orbitals which form conjugation. The heteroatom may be selected from N, O, S, B, Si, P, Se, preferably from N, O and S. A heteroarylene ring may comprise at least 1 to 3 heteroatoms. Preferably, a heteroarylene ring may comprise at least 1 to 3 heteroatoms individually selected from N, S and/or O. Just as in case of "aryl"/"arylene", the term "heteroaryl" comprises, for example, spiro compounds in which two aromatic moieties are connected with each other, such as spiro[fluorene-9,9'-xanthene]. Further exemplary heteroaryl groups are diazine, triazine, dibenzofurane, dibenzothiofurane, acridine, benzoacridine, dibenzoacridine etc.

The term "alkenyl" as used herein refers to a group $-CR^1 = CR^2R^3$ comprising a carbon-carbon double bond.

The term "perhalogenated" as used herein refers to a hydrocarbyl group wherein all of the hydrogen atoms of the hydrocarbyl group are replaced by halogen (F, Cl, Br, I) atoms.

The term "alkoxy" as used herein refers to a structural fragment of the Formula -OR with R being hydrocarbyl, preferably alkyl or cycloalkyl.

The term "thioalkyl" as used herein refers to a structural fragment of the Formula -SR with R being hydrocarbyl, preferably alkyl or cycloalkyl.

The subscripted number n in $C_n$-heteroaryl merely refers to the number of carbon atoms excluding the number of

heteroatoms. In this context, it is clear that a $C_3$ heteroarylene group is an aromatic compound comprising three carbon atoms, such as pyrazol, imidazole, oxazole, thiazole and the like.

The term "heteroaryl" as used herewith shall encompass pyridine, quinoline, benzoquinoline, quinazoline, benzoquinazoline, pyrimidine, pyrazine, triazine, benzimidazole, benzothiazole, benzo[4,5]thieno[3,2-d]pyrimidine, carbazole, xanthene, phenoxazine, benzoacridine, dibenzoacridine and the like.

In the present specification, the term single bond refers to a direct bond.

The term "fluorinated" as used herein refers to a hydrocarbon group in which at least one of the hydrogen atoms comprised in the hydrocarbon group is substituted by a fluorine atom. Fluorinated groups in which all of the hydrogen atoms thereof are substituted by fluorine atoms are referred to as perfluorinated groups and are particularly addressed by the term "fluorinated".

In terms of the invention, a group is "substituted with" another group if one of the hydrogen atoms comprised in this group is replaced by another group, wherein the other group is the substituent.

In accordance with the present disclosure, as an illustrative example using an arbitrary group A in a formula showing the following binding situation,

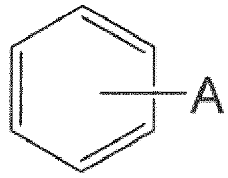

the group A may be bound to any suitable binding position. In a situation where it is shown that the bond of A crosses more than one ring

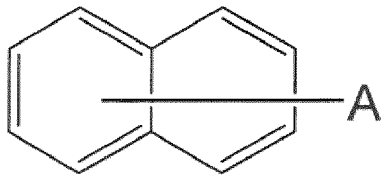

the group A may be bound to any suitable binding position of each ring crossed with the bond.

In terms of the invention, the expression "between" with respect to one layer being between two other layers does not exclude the presence of further layers which may be arranged between the one layer and one of the two other layers. In terms of the invention, the expression "in direct contact" with respect to two layers being in direct contact with each other means that no further layer is arranged between those two layers. One layer deposited on the top of another layer is deemed to be in direct contact with this layer.

The term "contacting sandwiched" refers to an arrangement of three layers whereby the layer in the middle is in direct contact with the two adjacent layers.

With respect to the inventive electron transport layer the compounds mentioned in the experimental part are most preferred.

A lighting device may be any of the devices used for illumination, irradiation, signaling, or projection. They are correspondingly classified as illuminating, irradiating, signaling, and projecting devices. A lighting device usually consists of a source of optical radiation, a device that transmits the radiant flux into space in the desired direction, and a housing that joins the parts into a single device and protects the radiation source and light-transmitting system against damage and the effects of the surroundings.

According to another aspect, the organic electroluminescent device according to the present invention comprises two or three or more emission layers. An OLED comprising more than one emission layer is also described as a tandem OLED or stacked OLED.

The organic electroluminescent device (OLED) may be a bottom- or top-emission device. The organic electroluminescent device (OLED) may emit the light through a transparent anode or through a transparent cathode.

Another aspect is directed to a device comprising at least one organic electroluminescent device (OLED).

A device comprising organic light-emitting diodes is for example a display or a lighting panel.

In the present invention, the following defined terms, these definitions shall be applied, unless a different definition is given in the claims or elsewhere in this specification.

In the context of the present specification the term "different" or "differs" in connection with the matrix material means that the matrix material differs in their structural Formula.

The terms "OLED" and "organic light-emitting diode" are used simultaneously and have the same meaning. The term "organic electroluminescent device" as used herein may comprise both organic light emitting diodes as well as organic light-emitting transistors (OLETs).

As used herein, "weight percent", "wt.-%", "percent by weight", "% by weight", and variations thereof refer to a composition, component, substance or agent as the weight of that component, substance or agent of the respective electron transport layer divided by the total weight of the respective electron transport layer thereof and multiplied by 100. It is under-stood that the total weight percent amount of all components, substances and agents of the respective electron transport layer and electron injection layer are selected such that it does not exceed 100 wt.-%.

As used herein, "volume percent", "vol.-%", "percent by volume", "% by volume", and variations thereof refer to a composition, component, substance or agent as the volume of that component, substance or agent of the respective electron transport layer divided by the total volume of the respective electron transport layer thereof and multiplied by 100. It is understood that the total volume percent amount of all components, substances and agents of the cathode layer are selected such that it does not exceed 100 vol.-%.

All numeric values are herein assumed to be modified by the term "about", whether or not explicitly indicated. As used herein, the term "about" refers to variation in the numerical quantity that can occur. Whether or not modified by the term "about" the claims include equivalents to the quantities.

It should be noted that, as used in this specification and the appended claims, the singular forms "a", "an", and "the" include plural referents unless the content clearly dictates otherwise.

The term "free of", "does not contain", "does not comprise" does not exclude impurities. Impurities have no technical effect with respect to the object achieved by the present invention.

In the context of the present specification the term "essentially non-emissive" or "non-emissive" means that the contribution of the compound or layer to the visible emission spectrum from the device is less than 10 %, preferably less than 5 % relative to the visible emission spectrum. The visible emission spectrum is an emission spectrum with a wavelength of about $\geq$ 380 nm to about $\leq$ 780 nm.

Preferably, the electron transport layer comprising the compound of Formula (I) is essentially non-emissive or non-emitting.

The operating voltage, also named U, is measured in Volt (V) at 10 milliampere per square centimeter ($mA/cm^2$).

The candela per ampere efficiency, also named cd/A efficiency or $C_{eff}$, is measured in candela per ampere at 10 milliampere per square centimeter ($mA/cm^2$).

The external quantum efficiency, also named EQE, is measured in percent (%).

The color space is described by coordinates CIE-x and CIE-y (International Commission on Illumination 1931). For blue emission the CIE-y is of particular importance. A smaller CIE-y denotes a deeper blue color. Efficiency values are compared at the same CIE-y.

The highest occupied molecular orbital, also named HOMO, and lowest unoccupied molecular orbital, also named LUMO, are measured in electron volt (eV).

The term "OLED", "organic light emitting diode", "organic light emitting device", "organic optoelectronic device" and "organic light-emitting diode" are simultaneously used and have the same meaning.

The term "life-span" and "lifetime" are simultaneously used and have the same meaning.

The anode and cathode may be described as anode electrode / cathode electrode or anode electrode / cathode electrode or anode electrode layer / cathode electrode layer.

Room temperature, also named ambient temperature, is 23° C.

Hereinafter, the embodiments are illustrated in more detail with reference to examples. However, the present disclosure is not limited to the following examples. Reference will now be made in detail to the exemplary aspects.

## DESCRIPTION OF THE FIGURES

The aforementioned components, as well as the claimed components and the components to be used in accordance with the invention in the described embodiments, are not subject to any special exceptions with respect to their size, shape, material selection and technical concept such that the selection criteria known in the pertinent field can be applied without limitations.

Additional details, characteristics and advantages of the object of the invention are disclosed in the dependent claims and the following description of the respective figures, which in an exemplary fashion show preferred embodiments according to the invention. Any embodiment does not necessarily represent the full scope of the invention, however, and reference is made therefore to the claims and herein for interpreting the scope of the invention. It is to be understood that both the foregoing general description and the following detailed description are exemplary and explanatory only and are intended to provide further explanation of the present invention as claimed.

FIG. 1 is a schematic sectional view of an OLED, according to an exemplary embodiment of the present invention.

Hereinafter, the figures are illustrated in more detail with reference to examples. However, the present disclosure

is not limited to the following figures.

Herein, when a first element is referred to as being formed or disposed "on" or "onto" a second element, the first element can be disposed directly on the second element, or one or more other elements may be disposed there between. When a first element is referred to as being formed or disposed "directly on" or "directly onto" a second element, no other elements are disposed there between.

Referring to Fig. 1, the OLED 100 according to an exemplary embodiment of the present disclosure includes a substrate 110, an anode 120, a first hole injection layer (HIL) 130, a first hole transport layer (HTL) 140, a first electron blocking layer (EBL) 145, a first emission layer (EML) 150, an auxiliary electron transport layer 155, wherein the auxiliary electron transport layer 155 may comprise the compound of formula (III), an electron transport layer (ETL) 160, wherein the electron transport layer 160 comprises the compound of formula (I), an n-type charge generation layer (n-type CGL) 185, wherein the n-type charge generation layer (n-type CGL) 185 comprises the heterocyclic compound nCG, a hole generating layer (p-type charge generation layer; p-type GCL) 135, a second hole transport layer (HTL) 141, a second electron blocking layer (EBL) 146, a second emission layer (EML) 151, a second hole blocking layer (HBL) 156, a second electron transport layer (ETL) 161 and an alkali metal complex, a second electron injection layer (EIL) 181 and a cathode 190.

While not shown in Fig. 1 a sealing layer may further be formed on the cathode electrodes 190, in order to seal the OLEDs 100. In addition, various other modifications may be applied thereto.

Hereinafter, the embodiments are illustrated in more detail with reference to examples. However, the present disclosure is not limited to the following examples.

EXPERIMENTAL PART

Dipole moment

The dipole moment $|\vec{\mu}|$ of a molecule containing N atoms is given by:

$$\vec{\mu} = \sum_{i}^{N} q_i \vec{r_i}$$

$$|\vec{\mu}| = \sqrt{\mu_x^2 + \mu_y^2 + \mu_z^2}$$

where $q_i$ and $\vec{r_i}$ are the partial charge and position of atom i in the molecule.

The dipole moment is determined by a semi-empirical molecular orbital method.

The geometries of the molecular structures are optimized using the hybrid functional B3LYP with the 6-31G* basis set in the gas phase as implemented in the program packageORCA V5.0.3 (Max Planck Institute für Kohlenforschung, Kaiser Wilhelm Platz 1, 45470, Muelheim/Ruhr, Germany) and WEASEL 1.9.2 (FAccTs GmbH, Rolandstrasse 67, 50677 Köln, Germany). If more than one conformation is viable, the conformation with the lowest total energy is selected to determine the bond lengths of the molecules.

Calculated HOMO, LUMP, T1 Triplett level

The HOMO and LUMO are calculated with the program package. ORCA V5.0.3 (Max Planck Institute für Kohlenforschung, Kaiser Wilhelm Platz 1, 45470, Muelheim/Ruhr, Germany) and WEASEL 1.9.2 (FAccTs GmbH, Rolandstrasse 67, 50677 Köln, Germany). The optimized geometries and the HOMO and LUMO energy levels of the molecular structures are determined by applying the hybrid functional B3LYP with a 6-31G* basis set in the gas phase. If more than one conformation is viable, the conformation with the lowest total energy is selected.

OLED Tests

To assess the performance of the inventive examples compared to the prior art, the current efficiency is measured at 20°C. The current-voltage characteristic is determined using a Keithley 2635 source measure unit, by sourcing a voltage in V and measuring the current in mA flowing through the device under test. The voltage applied to the device is varied in steps of 0.1V in the range between oV and 10V. Likewise, the luminance-voltage characteristics and CIE coordinates are determined by measuring the luminance in cd/m$^2$ using an Instrument Systems CAS-140CT array spectrometer

(calibrated by Deutsche Akkreditierungsstelle (DAkkS)) for each of the voltage values. The cd/A efficiency at 15 mA/cm2 is determined by interpolating the luminance-voltage and current-voltage characteristics, respectively.

In bottom emission devices, the emission is predominately Lambertian and quantified in percent external quantum efficiency (EQE). To determine the efficiency EQE in % the light output of the device is measured using a calibrated photodiode at 15 mA/cm2.

In top emission devices, the emission is forward directed, non-Lambertian and also highly dependent on the mirco-cavity. Therefore, the efficiency EQE will be higher compared to bottom emission devices. To determine the efficiency EQE in % the light output of the device is measured using a calibrated photodiode at 15 $mA/cm^2$.

Lifetime LT of the device is measured at ambient conditions (20°C) and 30 $mA/cm^2$, using a Keithley 2400 sourcemeter, and recorded in hours.

The brightness of the device is measured using a calibrated photo diode. The lifetime LT is defined as the time till the brightness of the device is reduced to 97 % of its initial value.

The increase in operating voltage ΔU is used as a measure of the operational voltage stability of the device. This increase is determined during the LT measurement and by subtracting the operating voltage after 1 hour after the start of operation of the device from the operating voltage after 100 hours.

$$\Delta U=[U100\ h)-\ U(1h)].$$

The smaller the value of ΔU the better is the operating voltage stability.

<u>References for used compounds</u>

| Compound | CAS-Number |
|---|---|
| ET-1 | CAS 2122309-39-9 |
| ET-6 | CAS 2358709-32-5 |
| ET-7 | CAS 2358709-35-8 |
| | |
| aET-1 | CAS 2937354-22-6 |
| aET-2 | CAS 2032364-64-8 |
| aET-3 | CAS 2941395-48-6 |
| aET-4 | CAS 2905346-60-1 |
| aET-5 | CAS 2905346-59-8 |
| aET-6 | CAS 2905406-10-0 |
| aET-7 | CAS 3024672-58-7 |
| | |
| nCG-1 | CAS 2646631-43-6 |
| nCG-2 | CAS 721969-94-4 |

<u>General procedure for fabrication of OLEDs</u>

ITO/HT-1:D-1 (1.5 vol%), 10 nm/HT-1, 28 nm/HT-2, 5nm/H09:BD200 (3%), 20nm/ comparative compound, 15nm/ nCG:Yb 2%, 7.5nm/HT-1:D-1 (10 vol%), 10nm/HT-1, 40 nm/HT-2, 5nm/H09:BD200 (3%), 20nm/ compound aET, 5nm /ET-1:LiQ 50%, 31 nm/Yb 2nm/Ag:Mg (90:10) vol%,13 nm/HT-1, 75 nm.

ITO/HT-1:D-1 (1.5 vol%), 10 nm/HT-1, 28 nm/HT-2, 5nm/H09:BD200 (3%), 20nm/ compound aET, 5nm/ compound of formula (I) 10 nm / nCG:Yb 2%, 7.5nm/HT-1:D-1 (10 vol%), 10nm/HT-1, 40 nm/HT-2, 5nm/H09:BD200 (3%), 20nm/ compound aET, 5nm /ET-1:LiQ 50%, 31 nm/Yb 2nm/Ag:Mg (90:10) vol%,13 nm/HT-1, 75 nm.

*Table 1: Used materials*

| | IUPAC name | Reference |
|---|---|---|
| HT-1 | N-([1,1'-biphenyl]-4-yl)-9,9-dimethyl-N-(4-(9-phenyl-9H-carbazol-3-yl)phenyl)-9H-fluoren-2-amine [CAS 1242056-42-3] | US2016322581 |
| HT-2 | N-([1,1'-biphenyl]-4-yl)-9,9-diphenyl-N-(4-(triphenylsilyl) phenyl)-9H-fluoren-2-amine [CAS 1613079-70-1] | - |
| D-1 | 4,4',4"-((1E,1'E,1"E)-cyclopropane-1,2,3-triylidenetris(cyanomethanylylidene))tris(2,3,5,6-tetrafluorobenzonitrile) [CAS 1224447-88-4] | US2008265216 |
| HOST-1 | H09 | Commercially available from Sun Fine Chemicals, Inc, S. Korea |
| EMITTER-1 | BD200 | Commercially available from Sun Fine Chemicals, Inc, S. Korea |
| ET-1 | 4'-(4-(4-(4,6-diphenyl-1,3,5-triazin-2-yl)phenyl)naphthalen-1-yl)-[1,1'-biphenyl]-4-carbonitrile [CAS 2032421-37-5] | WO 2016171406 |
| LiQ | 8-Hydroxyquinolinolato-lithium [CAS 850918-68-2] | WO2013079217 |

Comparative compounds

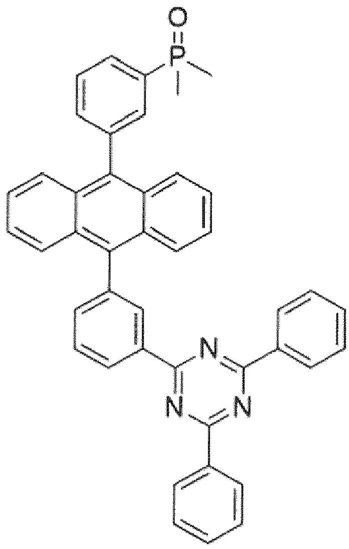

C-1 (Dipole moment: 4.47 D)

Tested compounds of formula (I)

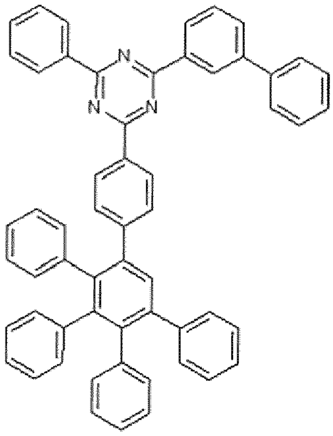
ET-1

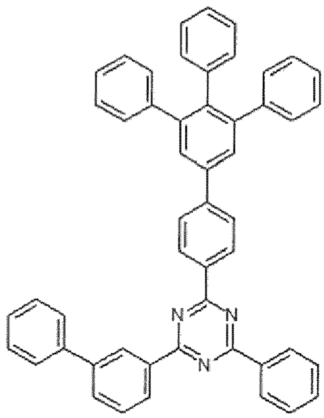
ET-2

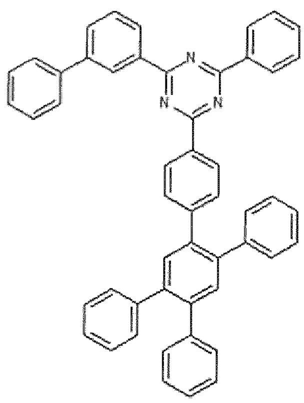
ET-4

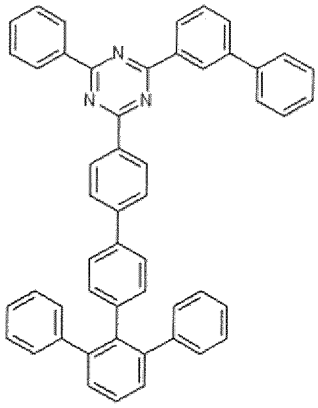
ET-5

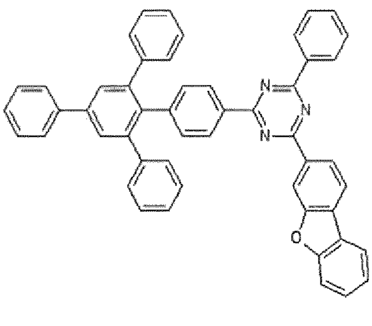
ET-6

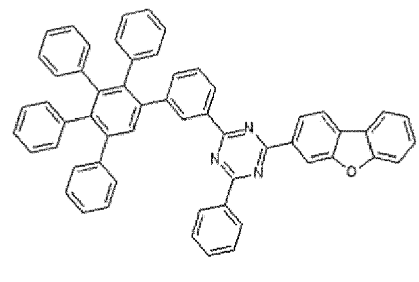
ET-7

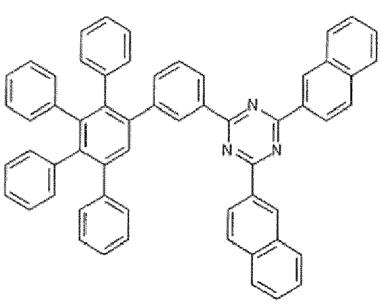
ET-8

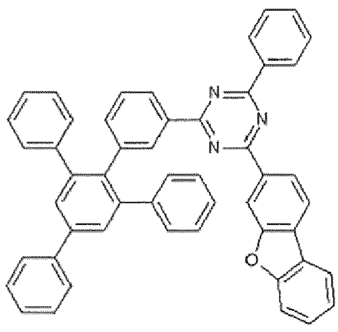
ET-9

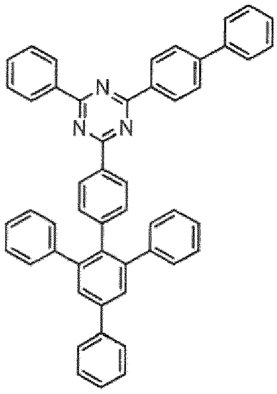

ET-14

Tested compounds aET

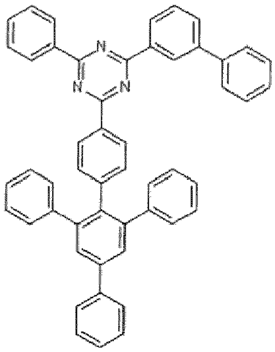

aET-1

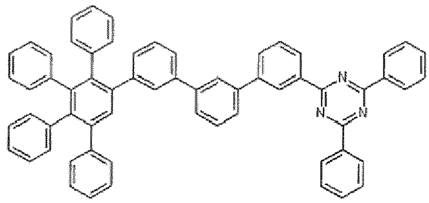

aET-2

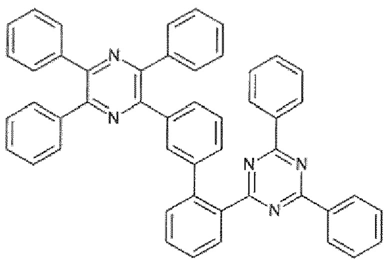

aET-3

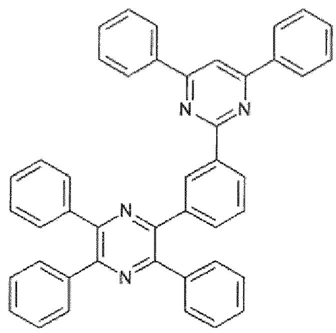

aET-4

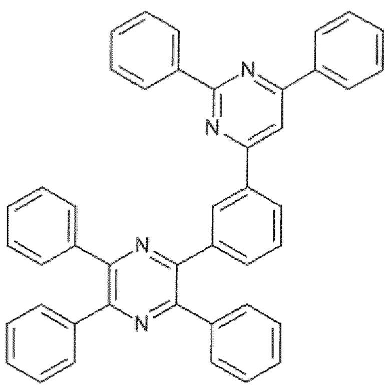

aET-5

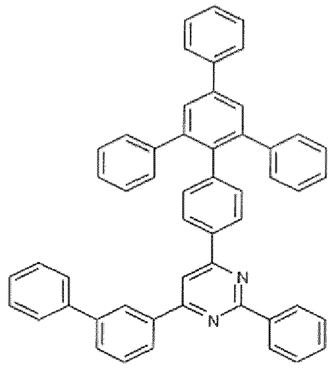

aET-6

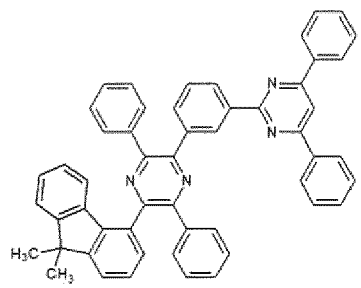

aET-7

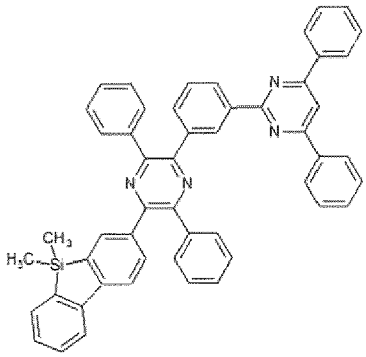

aET-8

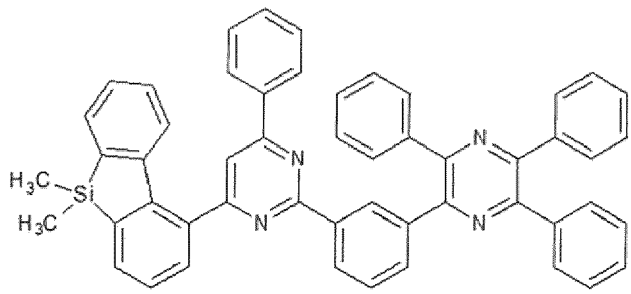

aET-9

Tested compounds nCG

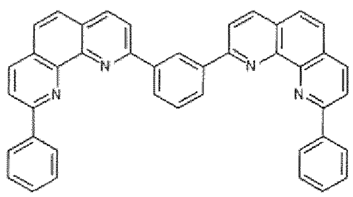

nCG-2

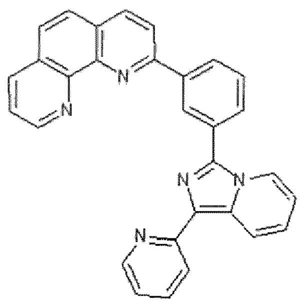

nCG-3

*Table 2: Device performance for OLEDs without aETL:*

| OLED device number | aETL | ETL | nCGL | Rel. V [%] at 10 mA/cm² | Rel. Ceff [%] | Rel. LT 97 [%] | Rel. V rise [%] |
|---|---|---|---|---|---|---|---|
| Comparative device | | C-1 | nCG-2 | 100 | 100 | 100 | 100 |
| | | | | | | | |
| OLED-1 | - | ET-1 | nCG-2 | 93 | 114 | 131 | 73 |
| OLED-2 | - | ET-2 | nCG-2 | 94 | 107 | 221 | 31 |
| OLED-3 | - | ET-14 | nCG-2 | 92 | 112 | 187 | 61 |
| OLED-4 | - | ET-4 | nCG-2 | 93 | 111 | 192 | 56 |
| OLED-5 | - | ET-5 | nCG-2 | 93 | 111 | 206 | 46 |
| OLED-6 | - | ET-6 | nCG-2 | 94 | 107 | 210 | 30 |
| OLED-7 | - | ET-7 | nCG-2 | 94 | 107 | 204 | 46 |

(continued)

| OLED device number | aETL | ETL | nCGL | Rel. V [%] at 10 mA/cm$^2$ | Rel. Ceff [%] | Rel. LT 97 [%] | Rel. V rise [%] |
|---|---|---|---|---|---|---|---|
| OLED-8 | - | ET-8 | nCG-2 | 96 | 104 | 115 | 45 |
| OLED-9 | - | ET-9 | nCG-2 | 94 | 108 | 173 | 46 |
| OLED-10 | - | ET-6 | nCG-3 | 94 | 109 | 185 | 34 |

*Table 3: Device performance for OLEDs with aETL:*

| OLED device number | aETL | ETL | nCGL | Rel. V [%] at 10 mA/cm$^2$ | Rel. Ceff [%] | Rel. LT 97 [%] | Ret. V rise [%] |
|---|---|---|---|---|---|---|---|
| OLED-11 | aET-1 | ET-2 | nCG-2 | 92 | 115 | 179 | 30 |
| OLED-12 | aET-2 | ET-2 | nCG-2 | 91 | 116 | 183 | 30 |
| OLED-13 | aET-3 | ET-2 | nCG-2 | 91 | 117 | 173 | 35 |
| OLED-14 | aET-4 | ET-2 | nCG-2 | 91 | 118 | 167 | 39 |
| OLED-15 | aET-5 | ET-2 | nCG-2 | 91 | 115 | 173 | 60 |
| OLED-16 | aET-1 | ET-5 | nCG-2 | 92 | 114 | 188 | 48 |
| OLED-17 | aET-1 | ET-6 | nCG-2 | 91 | 114 | 179 | 26 |
| OLED-18 | aET-2 | ET-6 | nCG-2 | 91 | 116 | 185 | 25 |
| OLED-19 | aET-3 | ET-6 | nCG-2 | 91 | 117 | 160 | 26 |
| OLED-20 | aET-6 | ET-6 | nCG-2 | 91 | 117 | 196 | 37 |
| OLED-21 | aET-4 | ET-6 | nCG-2 | 91 | 117 | 171 | 32 |
| OLED-22 | aET-5 | ET-6 | nCG-2 | 90 | 114 | 192 | 31 |
| OLED23 | aET-2 | ET-9 | nCG-2 | 91 | 116 | 185 | 29 |
| OLED-24 | aET-2 | ET-6 | nCG-3 | 92 | 116 | 160 | 37 |

The features disclosed in the foregoing description and in the dependent claims may, both separately and in any combination thereof, be material for realizing the aspects of the disclosure made in the independent claims, in diverse forms thereof.

## Claims

**1.** An organic light emitting diode comprising an anode, a cathode, a first emission layer, a second emission layer, an n-type charge generation layer, and an electron transport layer,
wherein

- the n-type charge generation layer is arranged between the first emission layer and the second emission layer;
- electron transport layer is arranged between the first emission layer and the second emission layer;
- the n-type charge generation layer comprises a heterocyclic compound nCG, wherein the heterocyclic compound nCG comprising at least one five-membered ring comprising at least one N-atom and/or at least one six-membered ring comprising at least one N-atom;
- the electron transport layer comprises a compound of Formula (I)

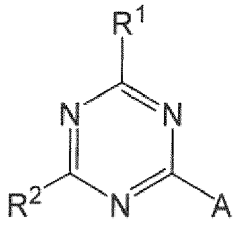

(I)

- $R^1$ is selected from the group consisting of unsubstituted or substituted $C_6$ to $C_{12}$ aryl,

  - wherein if $R^1$ is substituted $C_6$ to $C_{12}$ aryl, the one or more substituent(s) are independently selected from the group consisting of D, $C_1$ to $C_6$ alkyl, $C_1$ to $C_6$ alkoxy, partially or perfluorinated $C_1$ to $C_6$ alkyl, partially or perfluorinated $C_1$ to $C_6$ alkoxy, partially or perdeuterated $C_1$ to $C_6$ alkyl, partially or perdeuterated $C_1$ to $C_6$ alkoxy; halogen, CN or $PY(R^{10})_2$, wherein Y is selected from O, S or Se, and $R^{10}$ is independently selected from $C_6$ to $C_{12}$ aryl, $C_3$ to $C_{12}$ heteroaryl, $C_1$ to $C_6$ alkyl, $C_1$ to $C_6$ alkoxy, partially or perfluorinated $C_1$ to $C_6$ alkyl, partially or perfluorinated $C_1$ to $C_6$ alkoxy, partially or perdeuterated $C_1$ to $C_6$ alkyl, partially or perdeuterated $C_1$ to $C_6$ alkoxy;

- A is selected from the group consisting of unsubstituted or substituted $C_{10}$ to $C_{13}$ aryl and unsubstituted or substituted $C_{10}$ to $G_2$ heteroaryl,

  - wherein if A is substituted $C_{10}$ to $C_{13}$ aryl or substituted $C_{10}$ to $C_{12}$ heteroaryl, the one or more substituent(s) are independently selected from the group consisting of D, $C_1$ to $C_6$ alkyl, phenyl, $C_1$ to $C_6$ alkoxy, partially or perfluorinated $C_1$ to $C_6$ alkyl, partially or perfluorinated $C_1$ to $C_6$ alkoxy, partially or perdeuterated $C_1$ to $C_6$ alkyl, partially or perdeuterated $C_1$ to $C_6$ alkoxy; halogen, CN or $PY(R^{10})_2$, wherein Y is selected from O, S or Se, and $R^{10}$ is independently selected from $C_6$ to $C_{12}$ aryl, $C_3$ to $C_{12}$ heteroaryl, $C_1$ to $C_6$ alkyl, $C_1$ to $C_6$ alkoxy, partially or perfluorinated $C_1$ to $C_6$ alkyl, partially or perfluorinated $C_1$ to $C_6$ alkoxy, partially or perdeuterated $C_1$ to $C_6$ alkyl, partially or perdeuterated $C_1$ to $C_6$ alkoxy;

- $R^2$ is a group of Formula (II)

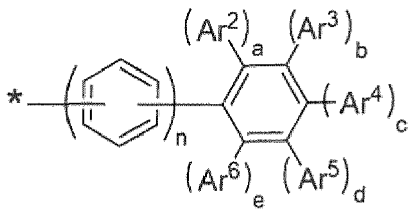

(II)

- * represents the binding position to the remaining structure of Formula (I);
- a, b, c, d, e are independently 0 or 1, wherein $1 \leq a+b+c+d+e \leq 5$;
- "n" is 0, 1, or 2;
- $Ar^2$, $Ar^3$, $Ar^4$, $Ar^5$, and $Ar^6$ are independently selected from the group consisting of substituted or unsubstituted $C_6$ to $C_{12}$ aryl and substituted or unsubstituted $C_4$ to $C_{10}$ heteroaryl,

  - wherein if one or more of $Ar^2$, $Ar^3$, $Ar^4$, $Ar^5$, and $Ar^6$ is substituted, the one or more substituent(s) are independently selected from the group consisting of D, $C_1$ to $C_6$ alkyl, $C_1$ to $C_6$ alkoxy, partially or perdeuterated $C_1$ to $C_6$ alkyl, partially or perdeuterated $C_1$ to $C_6$ alkoxy, partially or perfluorinated $C_1$ to $C_6$ alkyl, partially or perfluorinated $C_5$ to $C_6$ alkoxy, F, and CN;

- the dipole moment of the compound of Formula (I) is $\geq 0$ D and $\leq 1$ D;
- A is chosen so that the dipole moment of a compound "A-phenyl" is $\geq 0$ D and $\leq 1$ D; and
- the electron transport layer is free from an electrical dopant.

**2.** The organic light emitting diode according to claim 1, wherein $R^1$ is selected from the group consisting of phenyl, naphthyl and biphenyl.

3. The organic light emitting diode according to claim 1 or 2, wherein A is selected from the group consisting of naphthyl, biphenyl, and dibenzofuranyl.

4. The organic light emitting diode according to any of the preceding claims, wherein a, b, c, d, e are independently 0 or 1, wherein $2 \leq a+b+c+d+e \leq 4$.

5. The organic light emitting diode according to any of the preceding claims, wherein $Ar^2$, $Ar^3$, $Ar^4$, $Ar^5$, and $Ar^6$ are each phenyl.

6. The organic light emitting diode according to any of the preceding claims, wherein A is chosen so that the dipole moment of a compound "A-phenyl" is ≥ 0 D and < 1 D.

7. The organic light emitting diode according to any of the preceding claims, wherein the compound of Formula (I) is selected from ET-1 to ET-15

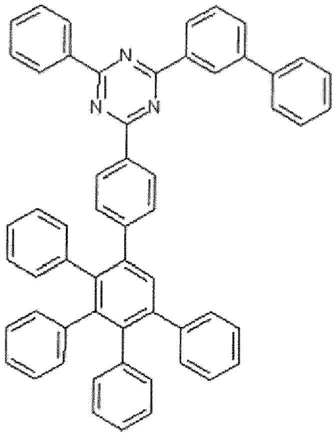

ET-1

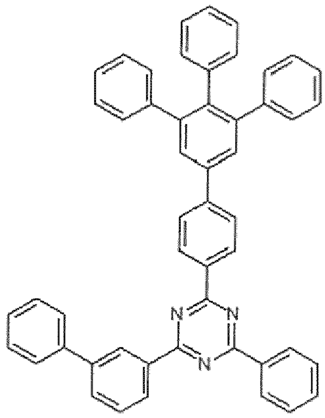

ET-2

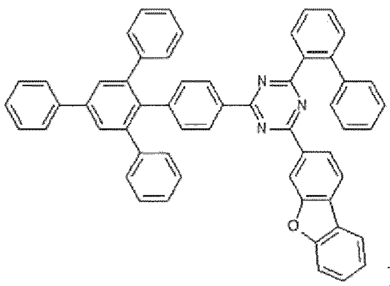

ET-3

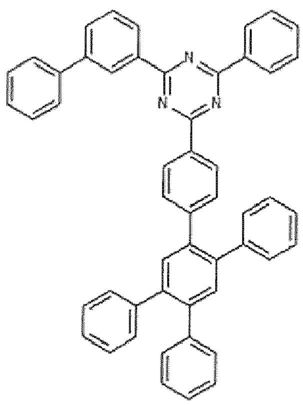

ET-4

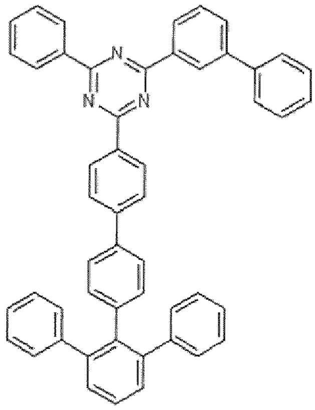

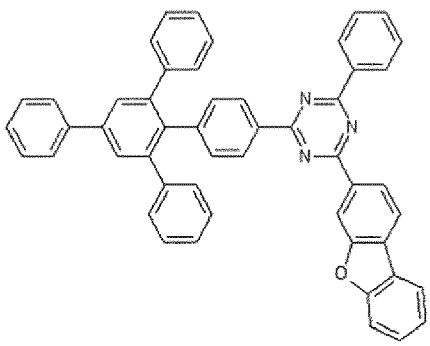

ET-5

ET-6

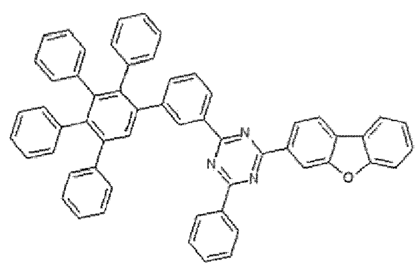

ET-7

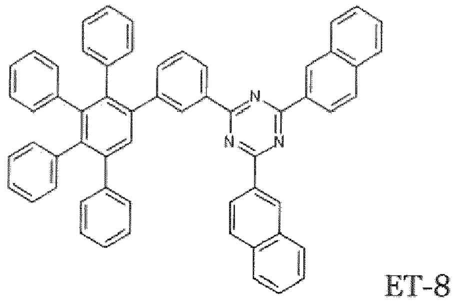

ET-8

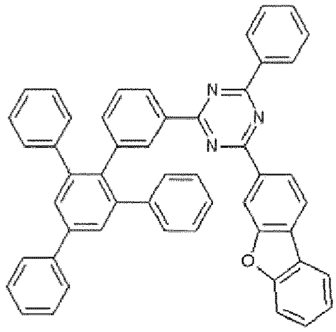

ET-9

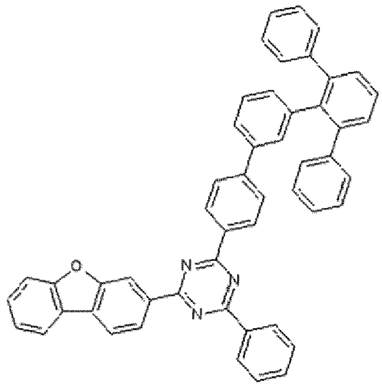

ET-10

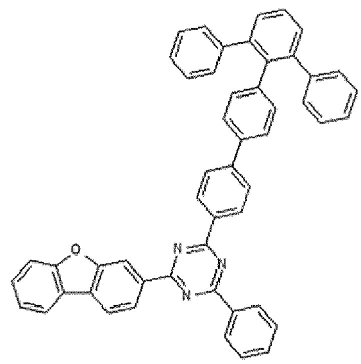

ET-11

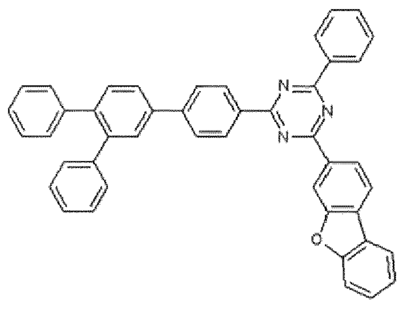

ET-12

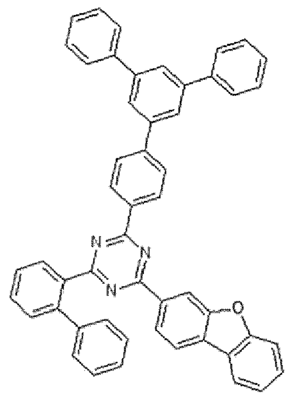

ET-13

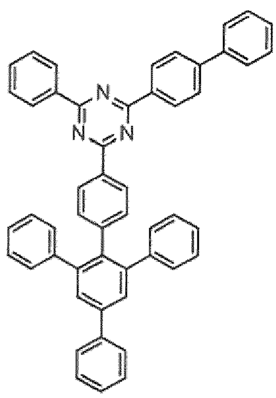

ET-14,

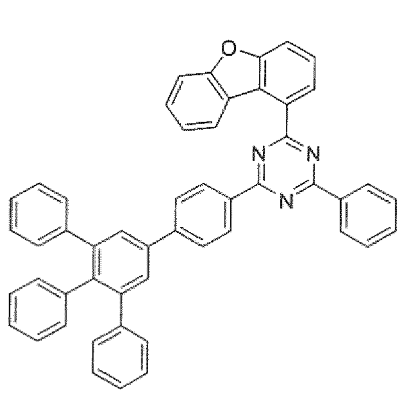

ET-15

**8.** The organic light emitting diode according to any of the preceding claims, wherein the organic light emitting diode further comprises an auxiliary electron transport layer, wherein

- the auxiliary electron transport layer is arranged between the first emission layer and the second emission layer;
- the auxiliary electron transport layer comprises a compound aET

wherein the LUMO energy level of the compound aET in the absolute scale taking vacuum energy level as zero, computed by the TURBO MOLE V6.5 program package using hybrid functional B3LYP and Gaussian 6-31G* basis set, is in the range from -1.90 eV to -1.50 eV.

**9.** The organic light emitting diode according to any of the preceding claims, wherein the organic light emitting diode further comprises an auxiliary electron transport layer, wherein

- the auxiliary electron transport layer is arranged between the first emission layer and the second emission layer;
- the auxiliary electron transport layer comprises a compound aET and the compound aET is a compound of Formula (III)

$$(Ar^1\text{-}R^3{}_p)_q\text{-}X_r \qquad \text{(III)}$$

- q and r are independently 1 or 2;
- p is independently 0 or 1;
- $Ar^1$ is independently selected from substituted or unsubstituted $C_6$ to $C_{60}$ aryl or substituted or unsubstituted $C_2$ to $C_{42}$ heteroaryl;

  - wherein if $Ar^1$ is substituted $C_6$ to $C_{60}$ aryl or substituted $C_2$ to $C_{42}$ heteroaryl the one or more substituent(s) are independently selected from the group consisting of D, $C_1$ to $C_6$ alkyl, $C_1$ to $C_6$ alkoxy, partially or perfluorinated $C_1$ to $C_6$ alkyl, partially or perfluorinated $C_3$ to $C_6$ alkoxy, partially or perdeuterated $C_1$ to $C_6$ alkyl, partially or perdeuterated $C_1$ to $C_6$ alkoxy; $C_6$ to $C_{12}$ aryl, $C_3$ to $C_{11}$ heteroaryl, halogen, CN or $PY(R^{10})_2$, wherein Y is selected from O, S or Se, and $R^{10}$ is independently selected from $C_6$ to $C_{12}$ aryl, $C_3$ to $C_{12}$ heteroaryl, $C_1$ to $C_6$ alkyl, $C_1$ to $C_6$ alkoxy, partially or perfluorinated $C_1$ to $C_6$ alkyl, partially or perfluorinated $C_1$ to $C_6$ alkoxy, partially or perdeuterated $C_1$ to $C_6$ alkyl, partially or perdeuterated $C_1$ to $C_6$ alkoxy,
  - wherein each $C_6$ to $C_{12}$ aryl substituent on $Ar^1$ and each $C_3$ to $C_{11}$ heteroaryl substituent on $Ar^1$ may be substituted with one or more selected from $C_1$ to $C_4$ alkyl or halogen;

- $R^3$ is independently selected from substituted or unsubstituted $C_6$ to $C_{30}$ aryl;

  - wherein if $R^3$ is substituted $C_6$ to $C_{30}$ aryl the one or more substituent(s) are independently selected from the group consisting of D, $C_1$ to $C_6$ alkyl, $C_1$ to $C_6$ alkoxy, partially or perfluorinated $C_1$ to $C_6$ alkyl, partially or perfluorinated $C_1$ to $C_6$ alkoxy, partially or perdeuterated $C_1$ to $C_6$ alkyl, partially or perdeuterated $C_1$ to $C_6$ alkoxy; $C_6$ to $C_{12}$ aryl, $C_3$ to $C_{11}$ heteroaryl, halogen, CN or $PY(R^{10})_2$, wherein Y is selected from O, S or Se, and $R^{10}$ is independently selected from $C_6$ to $C_{12}$ aryl, $C_3$ to $C_{12}$ heteroaryl, $C_1$ to $C_6$ alkyl, $C_1$ to $C_6$ alkoxy, partially or perfluorinated $C_1$ to $C_6$ alkyl, partially or perfluorinated $C_1$ to $C_6$ alkoxy, partially or perdeuterated $C_1$ to $C_6$ alkyl, partially or perdeuterated $C_1$ to $C_6$ alkoxy,
  - wherein each $C_6$ to $C_{12}$ aryl substituent on $Ar^1$ and each $C_3$ to $C_{11}$ heteroaryl substituent on $Ar^1$ may be substituted with one or more selected from $C_1$ to $C_4$ alkyl or halogen;

- X is independently selected from the group consisting of substituted or unsubstituted $C_2$ to $C_{42}$ heteroaryl and substituted or unsubstituted $C_6$ to $C_{60}$ aryl,

  - wherein if X is substituted $C_2$ to $C_{42}$ heteroaryl or substituted $C_6$ to $C_{60}$ aryl the one or more substituent(s) are independently selected from the group consisting of D, $C_1$ to $C_6$ alkyl, $C_1$ to $C_6$ alkoxy, partially or perfluorinated $C_1$ to $C_6$ alkyl, partially or perfluorinated $C_1$ to $C_6$ alkoxy, partially or perdeuterated $C_1$ to $C_6$ alkyl, partially or perdeuterated $C_1$ to $C_6$ alkoxy; $C_6$ to $C_{12}$ aryl, $C_3$ to $C_{11}$ heteroaryl, halogen, CN or $PY(R^{10})_2$, wherein Y is selected from O, S or Se, and $R^{10}$ is independently selected from $C_6$ to $C_{12}$ aryl, $C_3$ to $C_{12}$ heteroaryl, $C_1$ to $C_6$ alkyl, $C_1$ to $C_6$ alkoxy, partially or perfluorinated $C_1$ to $C_6$ alkyl, partially or perfluorinated $C_1$ to $C_6$ alkoxy, partially or perdeuterated $C_1$ to $C_6$ alkyl, partially or perdeuterated $C_1$ to $C_6$ alkoxy,
  - wherein each $C_6$ to $C_{12}$ aryl substituent on $Ar^1$ and each $C_3$ to $C_{11}$ heteroaryl substituent on $Ar^1$ may be substituted with one or more selected from $C_1$ to $C_4$ alkyl or halogen; and

- the molecular dipole moment of the compound of formula (III) is $\geq 0$ D and $\leq 4$ D.

**10.** The organic light emitting diode according to claim 9, wherein the compound of formula (III) is selected from aET-1 to aET-9

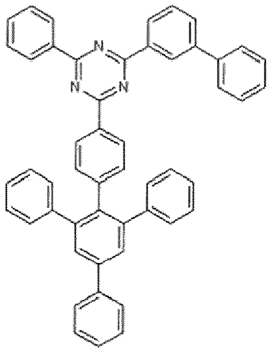

aET-1

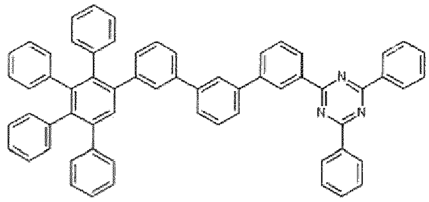

aET-2

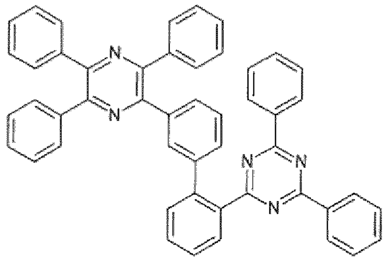

aET-3

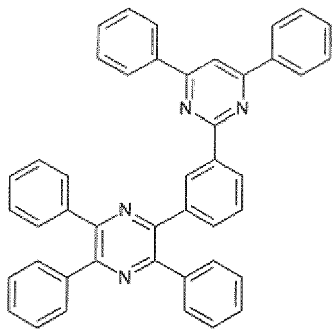

aET-4

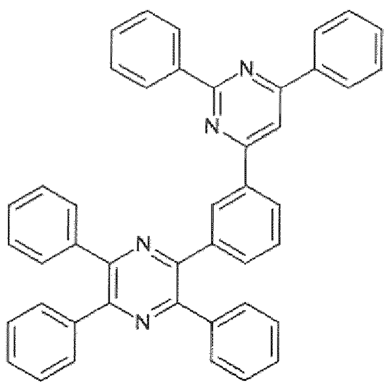

aET-5

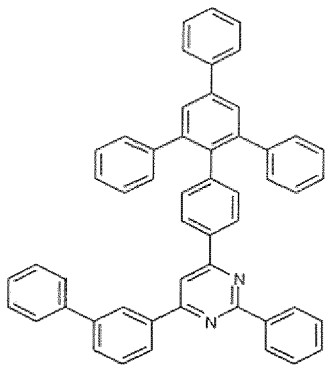

aET-6

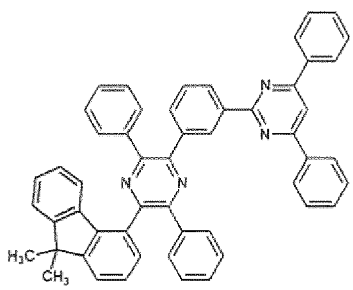

aET-7

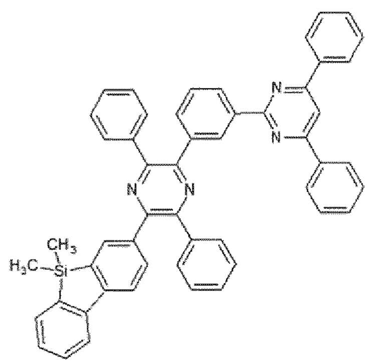

aET-8

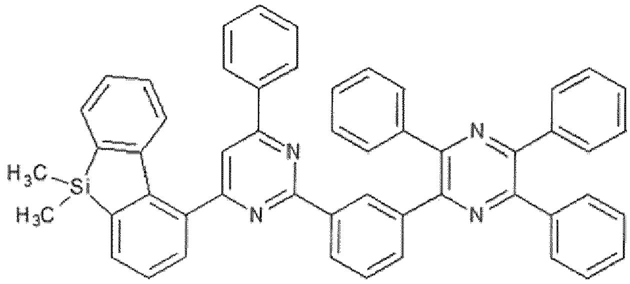

aET-9

11. The organic light emitting diode according to claim 8 to 10, wherein the auxiliary electron transport layer is arranged between the electron transport layer and the first emission layer.

12. The organic light emitting diode according to any one of the claims 8 to 11, wherein the electron transport layer is arranged between the auxiliary electron transport layer and the n-type charge generation layer.

13. The organic light emitting diode according to any of the preceding claims, wherein heterocyclic compound nCG comprises at least two moieties selected from the group consisting of bipyridine, 1,10-phenanthroline, pyridine-benzimidazole, and dibenzoacridine.

14. The organic light emitting diode according to any of the preceding claims, wherein heterocyclic compound nCG is selected from nCG-1 to nCG-3

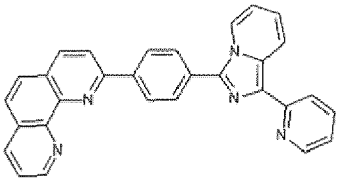

nCG-1

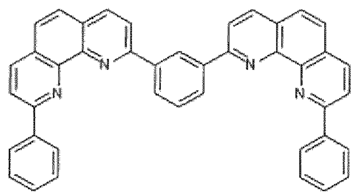

nCG-2

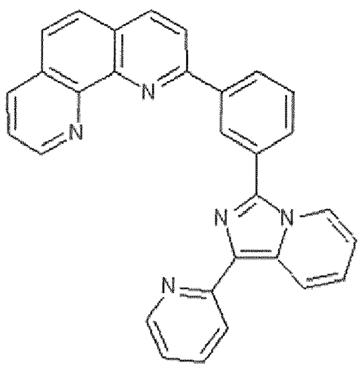

nCG-3.

15. Display device comprising the organic light emitting diode according to any of the preceding claims.

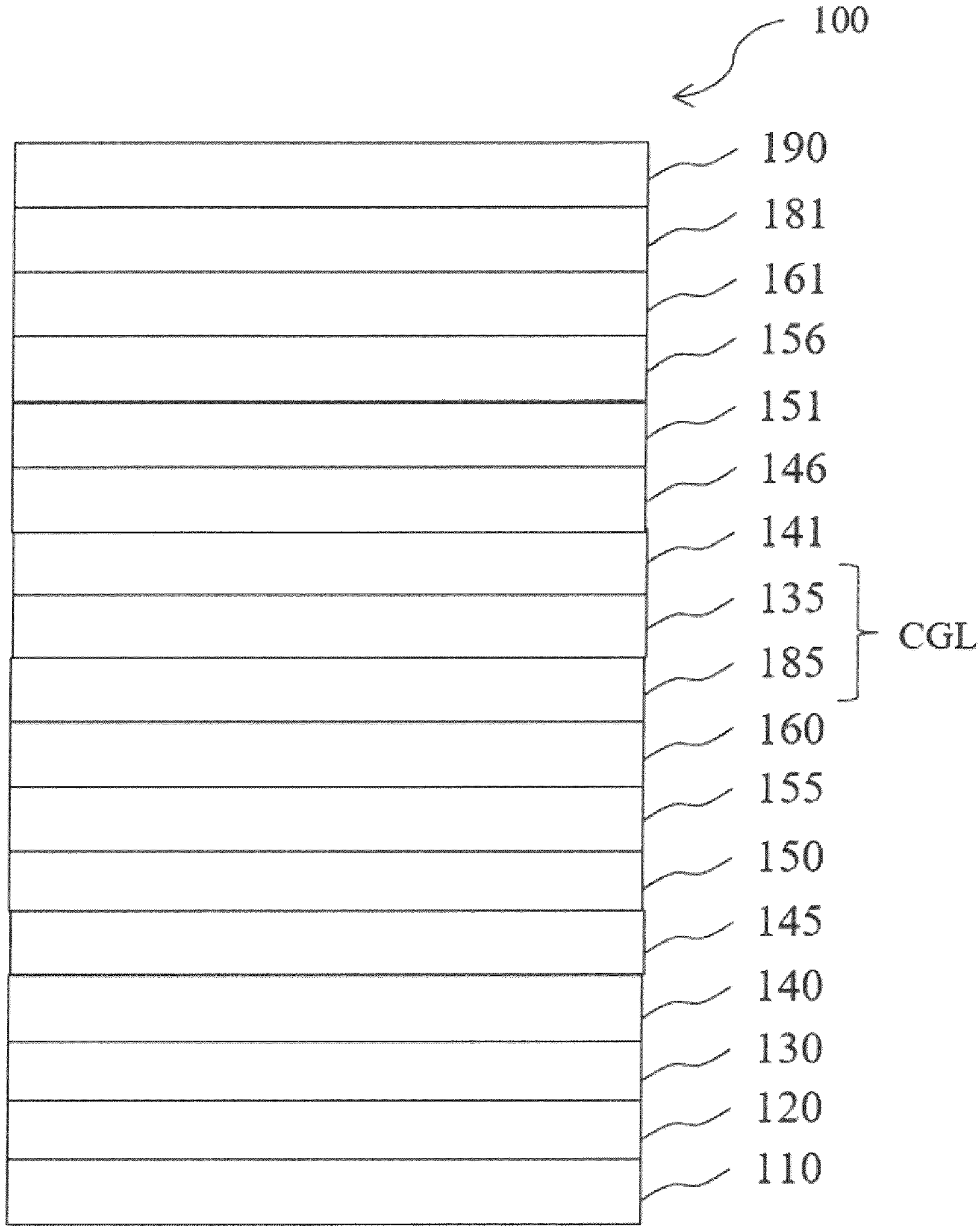
100
190
181
161
156
151
146
141
135
185
CGL
160
155
150
145
140
130
120
110

Fig. 1

Europäisches Patentamt
European Patent Office
Office européen des brevets

# EUROPEAN SEARCH REPORT

Application Number
EP 24 18 2648

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2023/292595 A1 (WERNER ANSGAR [DE] ET AL) 14 September 2023 (2023-09-14)<br>* page 67, paragraph 651; example OLED 8; table 7 *<br>----- | 1-6,8-15 | INV.<br>H10K50/16<br>H10K59/32<br>H10K85/40<br>H10K85/60<br>C07D253/075 |
| X | EP 4 199 133 A1 (NOVALED GMBH [DE]) 21 June 2023 (2023-06-21)<br>* page 38, paragraph 195 - page 41, paragraph 198; table 2b *<br>----- | 1-7,15 | |
| | | | TECHNICAL FIELDS SEARCHED (IPC) |
| | | | H10K<br>H05B<br>C07D |

The present search report has been drawn up for all claims

| Place of search | Date of completion of the search | Examiner |
|---|---|---|
| The Hague | 8 November 2024 | Parashkov, Radoslav |

1

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons
& : member of the same patent family, corresponding document

EPO FORM 1503 03.82 (P04C01)

## ANNEX TO THE EUROPEAN SEARCH REPORT ON EUROPEAN PATENT APPLICATION NO. EP 24 18 2648

This annex lists the patent family members relating to the patent documents cited in the above-mentioned European search report. The members are as contained in the European Patent Office EDP file on
The European Patent Office is in no way liable for these particulars which are merely given for the purpose of information.

08-11-2024

| Patent document cited in search report | Publication date | Patent family member(s) | Publication date |
|---|---|---|---|
| US 2023292595 A1 | 14-09-2023 | CN 115413374 A | 29-11-2022 |
| | | EP 3923364 A1 | 15-12-2021 |
| | | EP 4165693 A1 | 19-04-2023 |
| | | JP 2023528987 A | 06-07-2023 |
| | | KR 20230024869 A | 21-02-2023 |
| | | TW 202212301 A | 01-04-2022 |
| | | US 2023292595 A1 | 14-09-2023 |
| | | WO 2021250277 A1 | 16-12-2021 |
| EP 4199133 A1 | 21-06-2023 | EP 4199133 A1 | 21-06-2023 |
| | | KR 20240126043 A | 20-08-2024 |
| | | WO 2023117255 A1 | 29-06-2023 |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- WO 2005086251 A
- EP 1837926 B1
- WO 2007107306 A
- WO 2007107356 A
- EP 2722908 A1
- EP 1970371 A1
- WO 2013079217 A1
- US 2016322581 A
- US 2008265216 A
- WO 2016171406 A
- WO 2013079217 A


### Non-patent literature cited in the description


- **YASUHIKO SHIROTA** ; **HIROSHI KAGEYAMA**. *Chem. Rev.*, 2007, vol. 107, 953-1010
- *CHEMICAL ABSTRACTS*, 2122309-39-9
- *CHEMICAL ABSTRACTS*, 2358709-32-5
- *CHEMICAL ABSTRACTS*, 2358709-35-8
- *CHEMICAL ABSTRACTS*, 2937354-22-6
- *CHEMICAL ABSTRACTS*, 2032364-64-8
- *CHEMICAL ABSTRACTS*, 2941395-48-6
- *CHEMICAL ABSTRACTS*, 2905346-60-1
- *CHEMICAL ABSTRACTS*, 2905346-59-8
- *CHEMICAL ABSTRACTS*, 2905406-10-0
- *CHEMICAL ABSTRACTS*, 3024672-58-7
- *CHEMICAL ABSTRACTS*, 2646631-43-6
- *CHEMICAL ABSTRACTS*, 721969-94-4
- *CHEMICAL ABSTRACTS*, 1242056-42-3
- *CHEMICAL ABSTRACTS*, 1613079-70-1
- *CHEMICAL ABSTRACTS*, 1224447-88-4
- *CHEMICAL ABSTRACTS*, 2032421-37-5
- *CHEMICAL ABSTRACTS*, 850918-68-2